# EUROPEAN PATENT SPECIFICATION

(11) **EP 0 262 160 B1**
(45) Date of publication and mention of the grant of the patent: **03.03.1993**
(21) Application number: 87901183.1
(22) Date of filing: 27.01.1987
(51) Int. Cl.: H04S 1/00, H03G 5/02

(54) **STEREO ENHANCEMENT SYSTEM**
STEREOHEBUNGSSYSTEM
SYSTEME D'AMELIORATION D'IMAGES SONORES STEREO

(30) Priority: 27.03.1986 US 844929; 12.11.1986 US 929452
(43) Date of publication of application: 06.04.1988
(60) Divisional application: 91203173.9
(73) Proprietor: SRS LABS, Inc., Newport Beach, California 92660 (US)
(72) Inventor: KLAYMAN, Arnold, I., Huntington Beach, CA 92649 (US)
(74) Representative: Colgan, Stephen James
(86) International application number: PCT/US87/00099
(87) International publication number: WO 87/06090

(56) References cited:
- EP-A- 0 097 982
- US-A- 3 772 479
- US-A- 3 943 293
- US-A- 3 989 897
- US-A- 4 349 698
- US-A- 4 356 349
- US-A- 4 393 270
- US-A- 4 394 536

## Description

The disclosed invention generally relates to an enhancement system for stereo sound reproduction systems, and is particularly directed to a stereo enhancement system which broadens the stereo sound image, provides for an increased stereo listening area, and provides for perspective correction for the use of speakers or headphones.

As used herein, the phrase "selectively altering the relative amplitudes of frequency components of said difference signal such that louder frequency components of said difference signal are attenuated relative to quieter frequency components of said difference signal" and similar phrases (such as "... modified such that louder frequency components of said input difference signal are attenuated relative to quieter frequency components of said input difference signal") includes both attenuation of the louder frequency components and boosting of the quieter frequency components. Equally, the phrase "selectively altering the relative amplitudes of frequency components of said sum signal such that selected sum signal components are boosted relative to other sum signal components" and similar phrases (such as "... modified such that selected input sum signal components are boosted relative to other input sum signal components") includes both boosting of the selected sum signal components and attenuation of the other components.

Additionally, as used herein, the terms "boost", "enhance" and "emphasise" and the like are generally used interchangeably, as are the terms "attenuate" and "deemphasise" and the like.

Also, as used herein, the term "fixed medium" includes phonograph records, digital discs, magnetic tape and the like.

As is well known, a stereo sound reproduction system attempts to produce a sound image wherein the reproduced sounds are perceived as emanating from different locations, thereby simulating the experience of a live performance. The aural illusion of a stereo sound image is generally perceived as being between the speakers, and the width of the stereo image depends to a large extent on the similarity or dissimilarity between the information respectively provided to the left and right speakers. If the information provided to each speaker is the same, then the sound image will be centered between the speakers at "center stage." In contrast, if the information provided to each speaker is different, then the extent of the sound image will spread between the two speakers.

While the general concept of stereo sound imaging is not complex, its use and implementation is more difficult. The width of the stereo sound image depends not only on the information provided to the speakers, but also on listener position. Ideally, the listener is equidistant from the speakers. With many speaker systems, as the listener gets closer to one speaker, the sound from the more distant speaker contributes less to the stereo image, and the sound is quickly perceived as emanating only from the closer speaker.
This is particularly so when the information in each speaker is not very different. However, even with the listener equidistant from the speakers, the perceived sound image is generally between the physical locations of the speakers and does not extend beyond the region between the speakers.

Some known speaker systems have been designed to reduce the limitation that a listener should ideally be located equidistant between speakers. However, such speaker systems are generally complex and the resulting stereo image is still limited to the region between the physical locations of the speakers.

Another consideration in stereo sound reproduction is the fact that the sound transducers (typically speakers or headphones) are located at predetermined locations, and therefore provide sound emanating from such predetermined locations. However, in a live performance, the perceived sound may emanate from many directions as a result of the acoustics of the structure where the performance takes place. The human ears and brain cooperate to determine direction on the basis of different phenomena, including relative phase shift for low frequency sounds, relative intensity for sounds in the voice range, and relative time arrival for sounds having fast rise times and high frequency components.

As a result of the predetermined locations of speakers or headphones, a listener receives erroneous cues as to the directions from which the reproduced sounds are emanating. For example, for speakers located in front of the listener, sounds that should be heard from the side are heard from the front and therefore are not readily perceived as being sounds emanating from the sides. For headphones or side mounted speakers, sounds that should emanate from the front emanate from the sides. Thus, as a result of the placement of speakers or headphones, the sound perspective of a recorded performance is incorrect.

There have been numerous attempts to spread and widen the stereo image with mixed results. For example, it is known that the left and right stereo signals may be mixed to provide a difference signal (such as left minus right) and a sum signal (left plus right) which can be selectively processed and then mixed to provide processed left and right signals. Particularly, it is well known that increasing or boosting the difference signal produces a wider stereo image.

However, indiscriminately increasing the difference signal creates problems since the stronger frequency components of the difference signal tend to be concentrated in the mid-range. One problem is that the reproduced sound is very harsh and annoying since the ear has greater sensitivity to the range of about 1 KHz to about 4 KHz within the mid-range (herein called the "difference signal components of greater sensitivity"). Another problem is that the listener is limited to a position that is equidistant between speakers since the mid-range includes frequencies having wavelengths comparable to the distance between a listener's ears (which have frequencies in the range of between about 1 KHz and 2 KHz). As to such frequencies (herein called the "difference signal frequency components of increased phase sensitivity"), a slight shift in the position of the listener's head provides an annoying shift in the stereo image. Moreover, the perceived widening of the stereo image resulting from indiscriminate boosting of the difference signal is small, and is clearly not worth the attendant problems.

Some known stereo imaging systems require additional amplifiers and speakers. However, with such systems, the stereo image is limited by the placement of the speakers. Moreover, placing speakers at different locations does not necessarily provide the correct sound perspective.

With other systems, fixed or variable delays are provided. However, such delays interfere with the accuracy of the reproduced sound since whatever delays existed in the performance that was recorded are already present in the recording. Moreover, delays introduce further complexity and limit the listener's position.

There have also been attempts to correct or compensate the improper sound perspective resulting from the use of headphones. However, considerations with known headphone enhancement systems include complexity and lack of effectiveness.

Two particular stereo enhancement systems are disclosed in United States Patents Nos. 4356349 and 4349698.

It would be an advantage to provide a stereo enhancement system which extends the width of the stereo sound image beyond the region between the speakers.

It would also be an advantage to provide a stereo enhancement system which does not place constraint on listening position.

Another advantage would be to provide a stereo enhancement system which provides for a stereo sound image that may be perceived over a large listening area.

Still another advantage would be to provide a stereo correction system which provides for sound perspective correction for use with speakers or headphones.

The present invention seeks to achieve the foregoing and other features and advantages, and includes a stereo image enhancement system for providing a wider stereo image and listening area, and a perspective correction system which provides for sound perspective correction for use with speakers or headphones. The stereo image enhancement system and the perspective correction system may be utilized in combination or individually.

According to the present invention, there is provided apparatus for modifying stereo sum (L+R) and difference (L-R) signals derived from left (L) and right (R) stereo input signals to produce left (Lₒᵤₜ) and right (Rₒᵤₜ) stereo output signals, characterised by:- processing means responsive to said sum and difference signals for selectively altering the relative amplitudes of frequency components of said difference signal such that louder frequency components of said difference signal are attenuated relative to quieter frequency components of said difference signal, thereby providing a processed difference signal (L-R)ₚ, and for selectively altering the relative amplitudes of frequency components of said sum signal such that selected sum signal components are boosted relative to other sum signal components, thereby providing a processed sum signal (L+R)ₚ, and means responsive to said processed sum and difference signals to provide left (Lₒᵤₜ) and right (Rₒᵤₜ) stereo output signals.

A system according to the classifying portion of the preceding paragraph is disclosed in United States Patent No. US-A-4356349.

A wider stereo sound image and listening area may be achieved by this arrangement. The selective alteration of the difference signal provides for a wider stereo image and a wider listening area, and the selective alteration of the sum signal can prevent the sum signal from being overwhelmed by the difference signal.

In one preferred embodiment of the invention, a spectrum analyzer that is responsive to the difference signal controls the relative amplitudes of the difference signal frequency components so that the quieter difference signal frequency components are boosted relative to louder difference signal frequency components. The difference signal is also equalized by a fixed equalizer so that the difference signal frequencies having wavelengths comparable to the distance between a listener's ears are deemphasized. The spectrum analyzer further controls the relative amplitudes of the sum signal frequency components so that sum signal frequency components are boosted in proportion to the levels of corresponding difference signal frequency components.

In another preferred embodiment of the invention, the difference signal is equalized with a fixed difference signal equalizer so that difference signal frequency components that statistically include quieter difference components are boosted relative to difference signal frequency components that statistically include louder difference signal frequencies. The sum signal is equalized with a fixed sum signal equalizer so that the sum signal in the frequency range that statistically includes difference signal frequency components are boosted.

As a result of the selective alteration of the difference signal components, a wider stereo image is provided, and the harshness and image shifting problems associated with indiscriminate increase of the difference signal are substantially reduced by the equalization provided by the fixed equalizer utilized by the invention. The selective alteration of the difference signal components further enhances the stereo image for the following reasons. Ambient reflections and reverberant fields at a live performance are readily perceived and are not masked by the direct sounds. In a recorded performance, however, the ambient sounds are masked by the direct sounds, and are not perceived at the same level as at a live performance. The ambient sounds generally tend to be in the quieter frequencies of the difference signal, and boosting the quieter frequencies of the difference signal unmasks the ambient sounds, thereby simulating the perception of ambient sounds at a live performance.

The selective alteration of the difference signal also provides for a wider listening area for the following reasons. The louder frequency components of the difference signal tend to be in the mid-range which includes frequencies having wavelengths comparable to the ear-to-ear distance around the head of a listener (the previously mentioned "difference signal frequency components of increased phase sensitivity"). As a result of the selective alteration provided by the invention, the difference signal frequency components of increased phase sensitivity are not inappropriately boosted. Therefore, the stereo image shifting problem resulting from indiscriminate increase of the difference signal (discussed above in the background) is substantially reduced, and the listener is not limited to being equidistant from the speakers.

In providing the selective alteration of the difference signal, the amount of enhancement, which is determined by the level of the selectively boosted difference signal that is mixed, may be automatically adjusted so that the amount of stereo provided is relatively consistent. Without such automatic adjustment, the amount of enhancement provided would have to be manually adjusted for the differing amounts of stereo in different recordings.

The process of selectively altering the difference signal also boosts any artificial reverberation introduced in the recording process since artificial reverberation is predominantly in the difference signal. In order to avoid the inappropriate boosting of artificial reverberation, the enhancement system of the invention may also monitor the sum and difference signals for characteristics that indicate the possible presence of artificial reverberation. If the possibility of artificial reverberation is detected, the amount of boost provided for the difference signal is selectively reduced and the amount of boost for the sum signal is selectively increased.

A further aspect of the disclosed invention is a sound perspective correction system which provides perspective correction for recorded performances reproduced with speakers located at different positions or with headphones. The perspective correction system selectively modifies sum and difference signals derived from the left and right stereo signals so that the reproduced sounds are perceived as emanating from the directions a listener would expect at a live performance. Thus, with speakers located in front of the listener, sounds that should be heard as emanating from the sides are perceived as emanating from the sides. With headphones, sounds that should be heard as emanating from the front are perceived as emanating from the front.

The sound perspective correction system achieves perspective correction by generating sum and difference signals from left and right stereo signals, providing fixed equalization for the sum and difference signals to compensate for the variation with direction of the frequency response of the human ear, and combining the equalized sum and difference signals to produce left and right signals. For speakers located in front of the listener, the difference signal is selectively boosted so that side sounds are restored to the appropriate levels that would have been perceived had they been reproduced to emanate from the sides. For speakers located to the side or for headphones, the sum signal is selectively attenuated to restore front sounds to the appropriate levels that would have been perceived had they been reproduced to emanate from the front.

As indicated previously, the sound perspective correction system of the invention may be utilized in conjunction with the above-summarized stereo image enhancement system of the invention or may be utilized alone with other audio components.

Principles of the present invention are applicable both for playback of conventional stereo phonograph records, magnetic tapes and digital discs through a conventional sound reproducing system including a pair of loud-speakers and for making unique recordings on phonograph records, digital discs or magnetic tape which recordings can be played on a conventional sound reproducing system to produce left and right stereo output signals providing the advantageous effects described above.

The present invention extends to a method of modifying left and right stereo source signals as claimed in claim 10, to a medium carrying a stereo sound recording as claimed in claim 17, to a method of making a stereo sound recording from left and right stereo source signals as claimed in claim 21, and to a stereo signal as claimed in claim 26.

Further features of the invention are characterised in the dependent claims.

Preferred features of the invention will now be described, by way of example, with reference to the accompanying drawings wherein:
FIG. 1 is a block diagram of the stereo enhancement system of the invention.
FIG. 2 is a block diagram of a dynamic stereo image enhancement system in accordance with the invention which provides for dynamic equalization.
FIG. 3 is a block diagram of the feedback and reverberation control circuit for the stereo image enhancement systems of FIGS. 2 and 4.
FIG. 4 is a block diagram of a non-dynamic or fixed stereo image enhancement system in accordance with the invention which provides for fixed equalization.
FIGS. 5A and 5B are plots of the equalization provided by the fixed stereo image enhancement system of FIG. 4.
FIG. 6 is a block diagram of a sound perspective correction system in accordance with the invention.
FIGS. 7A and 7B are frequency responses of the human ear which are helpful in understanding stereo image enhancement systems of FIGS. 2 and 4 and the sound perspective correction system of FIG. 5.
FIG. 7C is the frequency response of FIG. 7A relative to FIG. 7B.
FIG. 7D is the frequency response of FIG. 7B relative to FIG. 7A.
FIGS. 8 and 9 illustrate sound reproducing and sound recording systems respectively, each of which employs either or both of the stereo image enhancement and perspective correction arrangements embodying principles of the present invention.
FIG. 10 is a block diagram of the stereo enhancement system having automatic and manual control of reverberation enhancement.
FIG. 11 shows an alternative attenuating reverberation filter.

### DETAILED DESCRIPTION OF THE DISCLOSURE

In the following detailed description and in the several figures of the drawing, like elements are identified with like reference numerals.

In order to facilitate the understanding of the invention, the following discussion is provided in different sections, with each subsequent section being more detailed than the previous section. Thus, an overview is first presented wherein the overall functions provided are discussed. Then, the invention is discussed in more detail with more emphasis on operating parameters.

### I. OVERVIEW

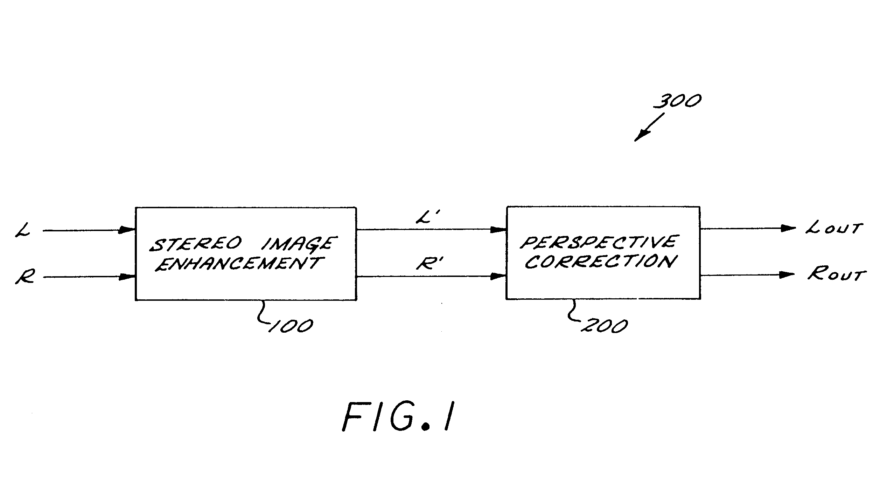

Referring now to FIG. 1, shown therein is a block diagram of the stereo enhancement system 300 of the invention, which includes a stereo image enhancement system 100 and a perspective correction system 200. The stereo image enhancement system 100 receives left and right stereo signals L and R and processes such signals to provide image enhanced left and right stereo signals L' and R' to the perspective correction system 200. The perspective correction system 200 processes the image enhanced stereo signals to provide image enhanced stereo signals which have been corrected to provide for proper sound perspective when amplified and played through speakers or headphones.

For use with standard commercially available audio components, the stereo enhancement system 300 of the invention may be utilized in the tape monitor loop or, if available, in an external processor loop of a preamplifier. Such loops are not affected by the preamplifier controls such as tone controls, balance control, and volume control. Alternatively, the stereo enhancement system 300 may be interposed between the preamplifier and power amplifier of a standard stereo sound reproduction system. However, with such installation, the balance and tone controls are preferably disabled or nulled.

The disclosed stereo enhancement system 300 may be readily incorporated for production into audio preamplifiers that are manufactured and sold as separate units, as well as into audio preamplifiers that are included in integrated amplifiers and receivers. As so incorporated, the stereo enhancement system 100 is preferably upstream of the tone and balance controls and preferably is capable of being bypassed.

It should be noted that the enhancement provided by the disclosed stereo enhancement system 300 can be advantageously utilized to enhance recordings. Such recordings can be played back on an audio system which does not include the stereo enhancement system 300, or an audio system which does include the stereo enhancement system 300 and which has been bypassed. Thus, for example, a recording which includes image enhancement and perspective correction can be made for playback in an automobile with side mounted speakers. It should be noted that perspective correction may not be desired in making recordings unless the playback conditions are known, e.g., that playback will be only through side mounted automobile speakers.

It should also be noted that the stereo image enhancement system 100 and/or the perspective correction 200 may be utilized independently in an audio system. Thus, for example, the perspective correction system 200 alone may be incorporated into an automobile audio system for correcting the improper sound perspective caused by side mounted speakers. Also, for cost considerations, the stereo image enhancement system 100 alone may be incorporated in an audio system for home use.

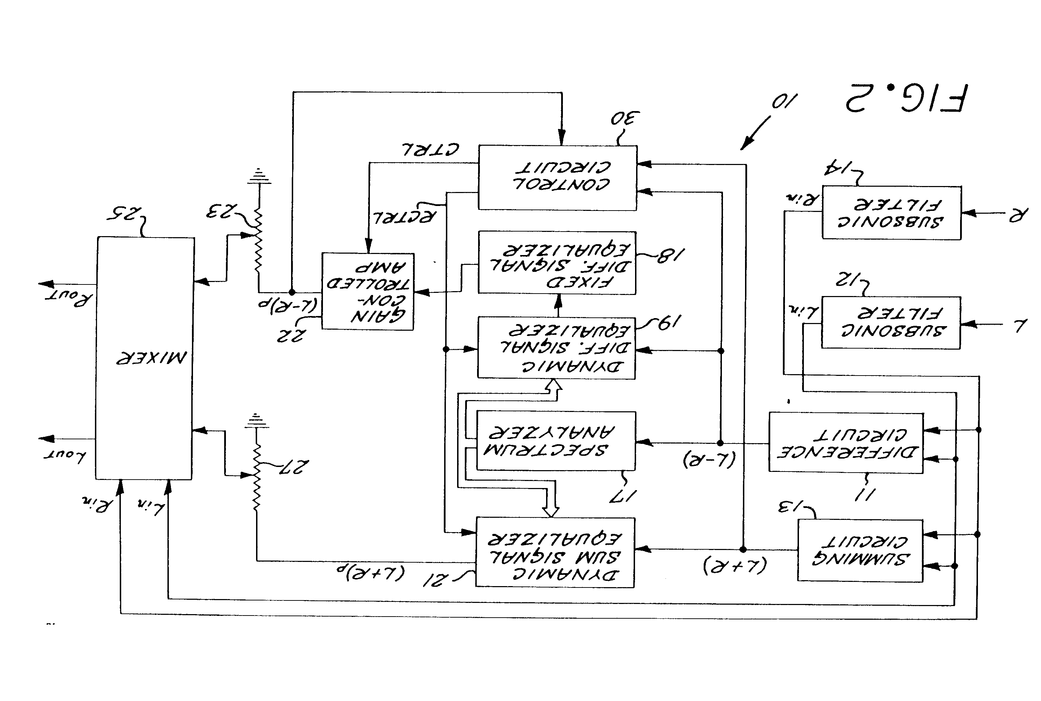

Referring to FIG. 2, shown therein is a block diagram of a stereo image enhancement system 10 which may be utilized as the stereo image enhancement system 100 in the stereo enhancement system 300 of FIG. 1, and which provides for dynamic equalization of the sum and difference of left and right stereo signals to achieve a wider stereo image and a wider listening area. Particularly, subsonically filtered left and right stereo signals L and R at the outputs of subsonic filters 12, 14 are provided to a difference circuit 11 and a summing circuit 13 which respectively provide a difference signal (L-R) and a sum signal (L+R). A dynamic difference signal equalizer 19, a fixed difference signal equalizer 18, and a gain controlled amplifier 22 cooperate to selectively alter or modify the relative amplitudes of the difference signal frequency components (also referred to herein as "components" or "frequencies") to provide a processed difference signal (L-R)ₚ. A dynamic sum signal equalizer 21 selectively alters or modifies the relative amplitudes of the sum signal frequency components (also referred to herein as "components" or "frequencies" to provide a processed sum signal (L+R)ₚ.)

A spectrum analyzer 17, which is responsive to the difference signal provided by the difference circuit 11, controls the dynamic difference signal equalizer 19 so that the quieter components of the difference signal are boosted relative to the louder components. More specifically, the dynamic difference signal equalizer 19 is controlled to attenuate the louder difference signal components more than the quieter difference signal components. The subsequent amplification of the equalized difference signal provides for a processed difference signal wherein the quieter components have been boosted relative to the louder difference signal components.

The fixed difference signal equalizer 18 selectively attenuates the equalized difference signal provided by the dynamic difference signal equalizer 19 to provide deemphasis in a predetermined manner.

The spectrum analyzer 17 also controls the sum signal equalizer so that components of the sum signal are boosted as a direct function of the levels of corresponding difference signal components. More specifically, the sum signal equalizer 21 boosts the sum signal to provide a processed sum signal wherein the sum signal components have been boosted in proportion to the amplitudes of correspondening difference signal amplitudes.

A feedback and reverberation control circuit 30 controls the gain of the gain controlled amplifier 22 so that the amount of stereo provided is relatively consistent from recording to recording. The control circuit 30 also controls the difference signal equalizer 19 and the sum signal equalizer 21 so that difference signal components that may include artificial reverberation are not inappropriately boosted when the possibility of artificial reverberation is detected. When the possibility of artificial reverberation is detected by the control circuit 30, the reverberation control signal RCTRL controls the dynamic difference signal equalizer 19 to provide further attenuation in selected frequency bands where artificial reverberation statistically occurs, and the dynamic sum signal equalizer 21 to provide further boost in such selected frequency bands. In this manner, any artificial reverberation which may be present in the difference signal is not inappropriately boosted in the subsequent amplification of the difference signal. The further boost of the sum signal ensures that the sum signal frequencies in the selected frequency bands are of sufficient level to compensate any artificial reverberation which may not have been sufficiently attenuated by the dynamic difference signal equalizer 19 pursuant to the reverberation control signal RCTRL.

The control circuit 30 is responsive to the sum and difference signals provided by the summing circuit 13 and the difference circuit 11, and also to the processed difference signal provided by the gain controlled amplifier 22.

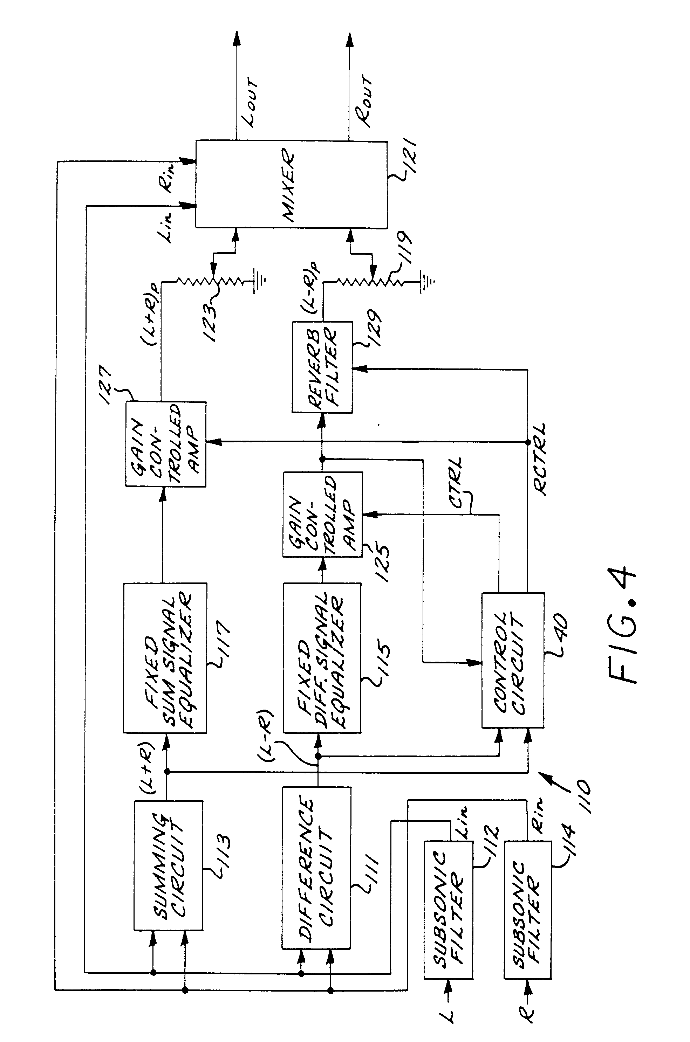

Referring now to FIG. 4, shown therein is a block diagram of a further embodiment of a stereo image enhancement system 110 which may be utilized as the stereo image enhancement system 100 in the stereo enhancement system of FIG. 1, and which provides for respective fixed equalization of the sum and difference of left and right stereo signals to achieve a wider stereo image and a wider listening area. Particularly, subsonically filtered left and right stereo signals L and R from subsonic filters 112, 114 are provided to a difference circuit 111 and a sum circuit 113 which generate respective difference and sum signals (L-R) and (L+R). A fixed difference signal equalizer 115, a gain controlled amplifier 125, and a reverberation filter 129 cooperate to selectively boost certain difference signal components relative to other difference signal components. A fixed sum signal equalizer 117 and a gain controlled amplifier 127 cooperate to selectively boost certain sum signal components relative to other sum signal components. Effectively, the sum and difference signals are respectively spectrally shaped or equalized in a fixed predetermined manner.

Particularly, the difference signal is equalized so that the frequencies where the quieter difference signal components statistically occur more frequently are boosted relative to the frequencies where the louder difference signal components statistically occur more frequently. The sum signal is equalized so that frequencies where the difference signal components statistically occur are boosted relative to other frequencies.

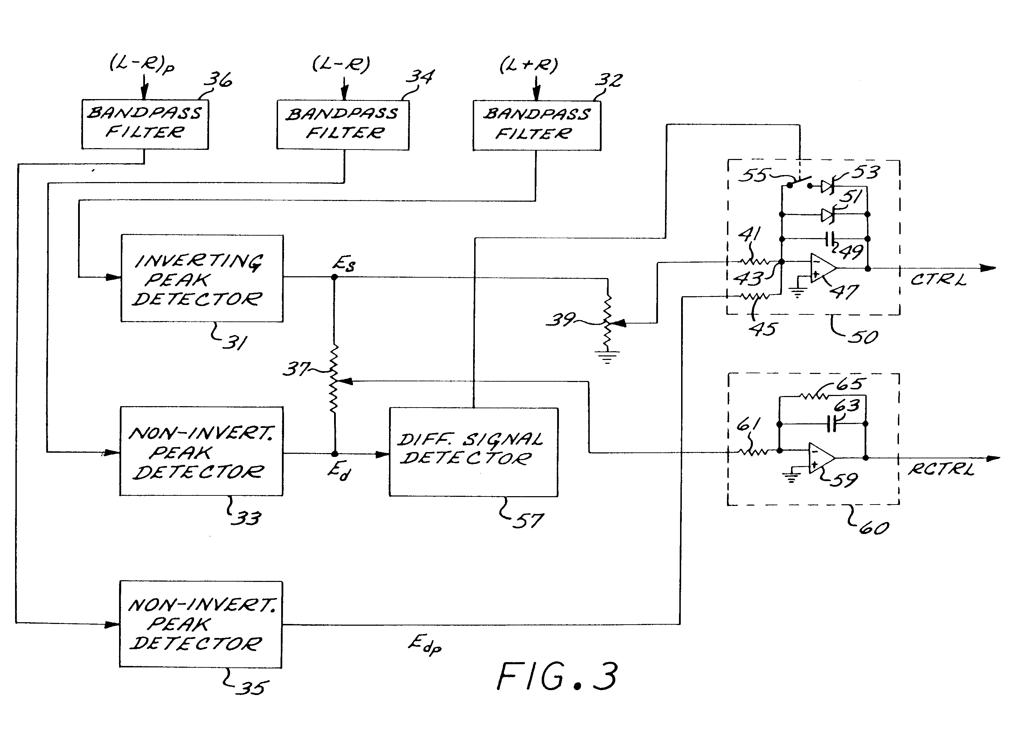

The stereo image enhancement system 110 further includes a feedback and reverberation control circuit 40 which is substantially similar to the control circuit 30 of FIGS. 2 and 3 and provides substantially similar functions. Particularly, the control circuit 40 cooperates with the gain controlled amplifier 125 so that substantially consistent stereo is provided for differing amounts of stereo within a given recording and between different recordings.

The control circuit 40 further cooperates with the gain controlled amplifier 127 and the reverberation filter 129 to compensate the effects of artificial reverberation. When the possibility of artificial reverberation is detected, the gain controlled amplifier 127 boosts the sum signal, and the reverberation filter 129 attenuates the difference signal components that statistically include artificial reverberation relative to other difference signal components. In this manner, the difference signal components that may include artificial reverberation are not inappropriately boosted. The further boost to the sum signal is to compensate for any artificial reverberation which may not have been sufficiently attenuated by the reverberation filter 129.

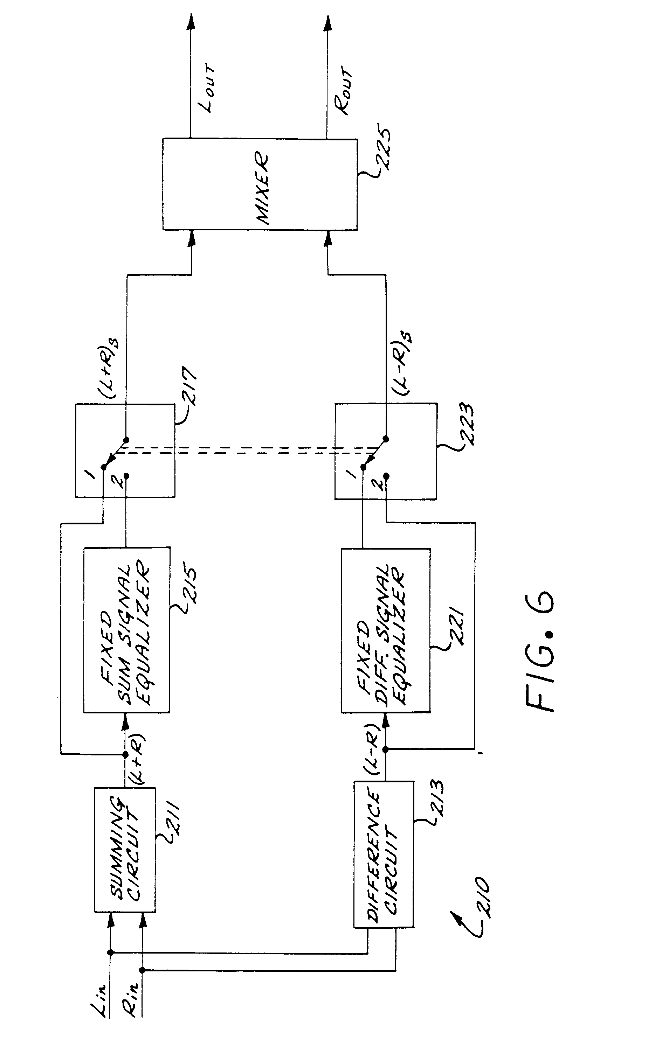

Referring now to FIG. 6, shown therein is a block diagram of a sound perspective correction system 210 which may be utilized as the sound perspective correction system 200 in the stereo enhancement system of FIG. 1. The perspective correction system 210 is responsive to left and right signals provided by the outputs of a stereo image enhancement system in accordance with the invention as discussed above relative to FIGS. 2 and 4. Alternatively, as discussed with reference to the stereo enhancement system 300 of FIG. 1, the left and right signals may be provided by an appropriate audio preamplifier.

The sound perspective correction system 210 includes a summing circuit 211 and a difference circuit 213 for respectively providing sum and difference signals (L+R) and (L-R). The sum and difference signals are respectively equalized by a fixed sum signal equalizer 215 and a fixed difference signal equalizer 221, which provide different equalization characteristics.

Particularly, the fixed sum signal equalizer 215 provides for one equalization output, and the fixed difference signal equalizer 221 provides for one equalization output. A pair of two position switches 217, 223 control whether equalized or non-equalized sum and difference signals are provided to a mixer 225. The selection of the signals provided to the mixer 225 is determined by the type of sound transducers (e.g., speakers or headphones) and/or the location of the sound transducers (e.g., front or side) used for sound reproduction. The mixer 225 mixes the sum and difference signals to provide processed left and right output signals which are the outputs of the sound perspective correction system 210. As discussed above relative to the stereo enhancement system 300 of FIG. 1, the outputs of the sound perspective system 210 may be provided to the preamplifier tape monitor loop input or to a standard power amplifier.

### II. DETAILED BLOCK DIAGRAM DISCUSSION

### A. The Dynamic Stereo Image Enhancement System

Referring again to FIG. 2, the stereo image enhancement system 10 of the invention includes a left input signal subsonic filter 12 and a right input signal subsonic filter 14 which are responsive to left and right stereo signals L and R provided by a stereo sound reproduction system (not shown). For example, the left and right stereo signals L and R may be provided by a preamplifier tape monitor loop output. The subsonic filters 12, 14 provide subsonically filtered input signals Lᵢₙ and Rᵢₙ to a difference circuit 11 and a summing circuit 13.

Each of the subsonic filters 12, 14 is a high pass filter having a -3 dB frequency of 30 Hz and a roll-off of 24 dB per octave. The sharp roll-off provides some protection against damage to speakers in the event a phono cartridge is accidentally dropped. Vertical displacement of a stylus due to dropping a phono cartridge is manifested as low frequency difference signal components with large amplitudes, which could be potentially damaging to speakers. The sharp subsonic filter roll-off cuts off such low frequency components to reduce the possibility of damage.

The difference circuit 11 subtracts the right subsonically filtered signal Rᵢₙ from the left subsonically filtered signal Lᵢₙ to provide a difference signal (L-R), while the summing circuit 13 adds the left and right subsonically filtered input signals Lᵢₙ and Rᵢₙ to provide a sum signal (L+R).

The difference signal (L-R) is provided to a multi-band spectrum analyzer 17. The difference signal (L-R) is further provided to a multi-band dynamic difference signal equalizer 19 which is controlled by control signals provided by the spectrum analyzer 17. The sum signal (L+R) is provided to a multi-band dynamic sum signal equalizer 21 which is also controlled by the control signals provided by the spectrum analyzer 17.

The multi-band spectrum analyzer 17 is responsive to predetermined frequency bands and provides respective control signals associated with each of the predetermined frequency bands. Particularly, such control signals are proportional to respective average amplitudes of the difference signal (L-R) within the respective predetermined frequency bands. By way of example, the multi-and spectrum analyzer 17 includes a plurality of one octave wide bandpass filters respectively centered in the predetermined frequency bands and respectively having roll-offs of 6 dB per octave. The respective outputs of the bandpass filters are rectified and appropriately buffered to provide the control signals.

The dynamic difference signal equalizer 19 is also responsive to the predetermined frequency bands and selectively cuts (attenuates) the difference signal frequencies in such predetermined frequency bands in response to the control signals provided by the spectrum analyzer 17. Specifically, the difference signal equalizer 19 attenuates the difference signal components within the respective predetermined frequency bands as a direct function of the respective control signals provided by the spectrum analyzer 17. That is, for a given frequency band, attenuation increases as the average amplitude of the difference signal (L-R) within such frequency band increases.

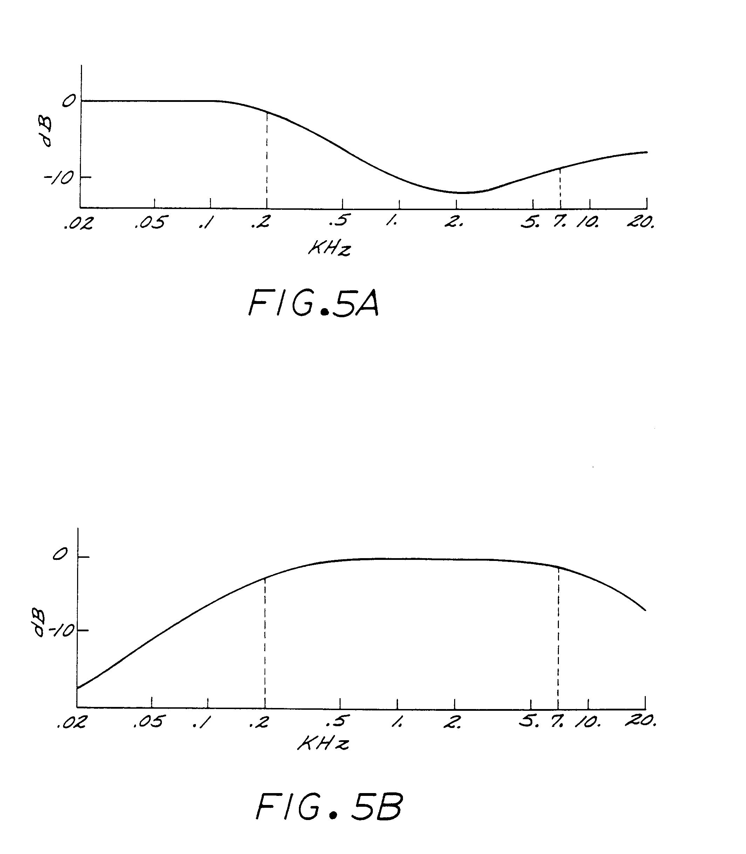

The output of the dynamic difference signal equalizer 19 is provided to a fixed difference signal equalizer 18 which attenuates selected frequencies of the dynamically equalized difference signal in a predetermined manner. An appropriate equalization characteristic for the fixed difference signal equalizer 18 is shown in FIG. 5A. By way of example, the fixed difference signal equalizer 18 may include a plurality of parallel filter stages including a low pass filter and a high pass filter having the following characteristics. The low pass filter has a -3 dB frequency of about 200 Hz, a roll-off of 6 dB per octave, and a gain of unity. The high pass filter has a -3 dB frequency of about 7 KHz, a roll-off of 6 dB per octave, and a gain of one-half.

The fixed equalization of the fixed difference equalizer 18 is provided (a) so that frequencies to which the ear has greater sensitivity (about 1 KHz to about 4 KHz) are not inappropriately boosted, and (b) so that difference signal components having wavelengths comparable to the distance between the ears of a listener (the previously discussed "difference signal components of increased phase sensitivity") are not inappropriately boosted. Alternatively, such fixed equalization may be provided prior to dynamic equalization.

The difference signal provided by the fixed difference signal equalizer 18 is amplified by a gain controlled amplifier 22 to provide a processed difference signal (L-R)ₚ.

The dynamic sum signal equalizer 21 is also responsive to the predetermined frequency bands and selectively boosts the sum signal frequencies in such predetermined frequency bands in response to the control signals provided by the spectrum analyzer 17. Specifically, the dynamic sum signal equalizer 21 boosts the sum signal components within the respective predetermined frequency bands as a direct function of the respective control signals provided by the spectrum analyzer 17. That is, for a given frequency band, boost increases as the average amplitude of the difference signal (L-R) within such frequency band increases. The output of the dynamic sum signal equalizer 21 is a processed sum signal (L+R)ₚ.

The predetermined frequency bands for the spectrum analyzer 17, the dynamic difference signal equalizer 19, and the dynamic sum signal equalizer 21 include seven (7) bands of one octave width each which are respectively centered at 125 Hz, 250 Hz, 500 Hz, 1 KHz, 2 KHz, 4 KHz, and 8 KHz. A larger or smaller number of predetermined frequency bands may be readily utilized.

The dynamic difference signal equalizer 19 provides for each of the frequency bands a maximum attenuation of 12 dB for the maximum level of the corresponding control signals provided by the spectrum analyzer 17. No attenuation would be provided for a control signal having a zero level. Similarly, the dynamic sum signal equalizer 21 provides for each of the frequency bands a maximum boost of 6 dB for the maximum level of the corresponding control signals provided by the spectrum analyzer 17. No boost would be provided for a control signal having a zero level.

The control signals provided by the spectrum analyzer 17 have a range between 0 volts and 8 volts. The corresponding range of attenuation provided by the dynamic difference signal equalizer 19 would be between 0 dB and -12 dB, while the corresponding range of boost provided by the sum signal equalizer 21 would be between 0 dB and 6 dB.

It should be readily apparent that for a given control signal for a particular frequency band, the value of the boost provided by the dynamic sum signal equalizer 21 is one-half of the value of the attenuation provided by the dynamic difference signal equalizer 19. Other ratios may be utilized, but it is important that the level of boost provided by the dynamic sum signal equalizer 21 be less than the corresponding level of attenuation provided by the dynamic difference signal equalizer 19. Such reduced boost has been found to be appropriate since most recordings include more sum signal than difference signal. A maximum boost level approaching the maximum attenuation level would result in inappropriately high levels of the processed sum signal (L+R)ₚ.

As discussed further herein, selected frequency bands of the dynamic difference signal equalizer 19 and the dynamic sum signal equalizer 21 are further responsive to other control signals. The foregoing discussion of the responses of such equalizers to the control signals provided by the spectrum analyzer were based on such other control signals having zero levels. To the extent that other control signals have non-zero levels, the total attenuation or boost is the superposition of the individual attenuation or boost due to the individual control signals. In other words, the respective control signals are added.

It should be noted that preferably the dynamic difference signal equalizer 19 is configured to provide for each of the frequency bands a maximum attenuation, such as 12 dB, in order to avoid inappropriate levels of attenuation. Similarly, the dynamic sum signal equalizer 21 is preferably configured to provide for each of the frequency bands a maximum boost, such as 6 dB, in order to avoid inappropriately high levels of boost.

The stereo image enhancement system 10 further includes a feedback and reverberation control circuit 30 which cooperates with other elements in the system to provide for automatic adjustment of the stereo image enhancement provided and for reverberation compensation. The characteristics of recordings that make automatic enhancement adjustment and reverberation compensation desirable are discussed further below.

The control circuit 30 (described in more detail below relative to FIG. 3) is responsive to the difference signal (L-R) provided by the difference circuit 11 and the sum signal (L+R) provided by the sum circuit 13. The control circuit 30 provides a gain control signal CTRL for controlling the gain controlled amplifier 22 which varies the gain applied to the difference signal provided by the fixed difference signal equalizer 18. The control circuit 30 is further responsive to the processed difference signal (L-R)ₚ provided by the gain controlled amplifier 22, thereby providing a closed loop system for controlling the processed difference signal (L-R)ₚ.

The control circuit 30 controls the gain of the gain controlled amplifier 22 to maintain a constant ratio between (1) the sum signal (L+R) provided by the summing circuit 13 and (2) the processed difference signal (L-R)ₚ output of the gain controlled amplifier 22. By way of example, the gain controlled amplifier 22 may be an appropriate voltage controlled amplifier.

The control circuit 30 further provides a reverberation control signal RCTRL to the difference signal equalizer 19 and the sum signal equalizer 21 for controlling the amount of equalization provided in the frequency bands centered at 500 Hz, 1 KHz, and 2 KHz (herein the "reverberation bands"). The presence of artificial reverberation, which is almost always in difference signal frequencies in the reverberation bands, is indicated by a larger than expected ratio between the sum signal and the difference signal, since a large ratio indicates the presence of a center stage soloist (vocalist or instrumentalist), which in turn indicates the possibility of artificial reverberation. The control circuit 30, therefore, monitors the ratio between the sum signal (L+R) and the difference signal (L-R). When the possible presence of artificial reverberation is detected (for example, when the sum signal to difference signal ratio is greater than a predetermined value), the reverberation control signal RCTRL provides further control of the reverberation bands in the difference signal equalizer 19 and the sum signal equalizer 21.

As to the difference signal equalizer 19, the reverberation control signal RCTRL causes further attenuation in the above specified reverberation bands in addition to the attenuation resulting from the control signals provided by the spectrum analyzer 17. As to the sum signal equalizer 21, the reverberation control signal RCTRL causes further boost in the above specified reverberation bands in addition to the boost resulting from the control signals provided by the spectrum analyzer 17.

The further attenuation of the difference signal components within the reverberation bands is to prevent any artificial reverberation which may be accompanying a soloist from being inappropriately boosted when the processed difference signal is subsequently amplified. The further boost of the sum signal components within the reverberation bands insures that the sum signal components in the reverberation bands are of sufficient level to compensate any artificial reverberation that is not sufficiently attenuated by the dynamic difference signal equalizer 19.

The dynamic difference signal equalizer 19 provides for each of the above specified reverberation bands a maximum attenuation of 12 dB for the maximum level of the reverberation control signal RCTRL, with no corresponding control signal from the spectrum analyzer 17 present. The total attenuation provided in response to both the reverberation control signal RCTRL and a corresponding control signal from the spectrum analyzer 17 would be the superposition of the respective attenuations in response to the individual control signals. However, as noted previously, the dynamic difference signal equalizer 19 is preferably configured to provide a predetermined maximum attenuation, such as 12 dB, regardless of the levels of the control signals.

The dynamic sum signal equalizer 21 provides for each of the above specified reverberation bands a maximum boost of 6 dB for the maximum level of the reverberation control signal RCTRL, with no corresponding control signal from the spectrum analyzer 17 present. The total boost provided in response to both the reverberation control signal RCTRL and a corresponding control signal from the spectrum analyzer 17 would be the superposition of the respective boosts in response to the individual control signals. However, as noted previously, the dynamic sum signal equalizer 21 is preferably configured to provide a predetermined maximum boost, such as 6 dB, regardless of the levels of the control signals.

Alternatively, reverberation compensation for the processed sum signal may be achieved by utilizing a gain controlled amplifier (not shown) to vary the gain applied to the equalized sum signal provided by the dynamic sum signal equalizer 21. Such gain controlled amplifier would amplify the processed sum signal as a function of the reverberation control signal RCTRL. If a gain controlled amplifier to amplify the processed sum signal is utilized to compensate the effects of artificial reverberation, the reverberation control signal RCTRL would not be provided to the dynamic sum signal equalizer 21.

The output of the gain controlled amplifier 22 is coupled to one fixed terminal of a potentiometer 23 which has its other fixed terminal coupled to ground. The wiper contact of the potentiometer 23 is coupled to a mixer 25 which therefore receives the processed difference signal (L-R)ₚ having a level controlled by the gain controlled amplifier 22 and the potentiometer 23.

As mentioned previously, the control circuit 30 and the gain controlled amplifier 22 control the ratio between the sum signal (L+R) provided by the summing circuit 13 and the processed difference signal (L-R)ₚ provided by the gain controlled amplifier 22. As discussed further herein, that ratio is controlled by circuitry within the control circuit 30. The potentiometer 23 provides further control over the amount of stereo enhancement provided.

The output of the dynamic sum signal equalizer 21 is coupled to one fixed terminal of a potentiometer 27 which has its other fixed terminal coupled to ground. The wiper contact of the potentiometer 27 is coupled to the mixer 25 which therefore receives the processed sum signal (L+R)ₚ having a level controlled by the potentiometer 27. The potentiometer 27 controls the level of the sound image at center stage.

The left and right subsonically filtered input signals Lᵢₙ and Rᵢₙ are provided as further inputs to the mixer 25. The mixer 25 combines the processed sum signal (L+R)ₚ and the processed difference signal (L-R)ₚ with the left and right input signals Lᵢₙ and Rᵢₙ to provide left and right output signals Lₒᵤₜ and Rₒᵤₜ. Particularly, the left and right output signals Lₒᵤₜ and Rₒᵤₜ are provided by the mixer 25 in accordance with the following:

${\text{L}}_{\text{out}} {\text{= L}}_{\text{in}} {\text{+ K₁(L+R)}}_{\text{p}} {\text{+ K₂(L-R)}}_{\text{p}} \text{(Equation 1)}$

${\text{R}}_{\text{out}} {\text{= R}}_{\text{in}} {\text{+ K₁(L+R)}}_{\text{p}} {\text{- K₂(L-R)}}_{\text{p}} \text{(Equation 2)}$

The value of K₁ is controlled by the potentiometer 27; and the value of K₂ is controlled by the potentiometer 23.

The overall effect of processing the difference signal (L-R) is that the quieter difference signal components are boosted relative to the louder difference signal components. That is, the selective attenuation of the difference signal followed by amplification provides a processed difference signal wherein the louder components may be comparable in level to their original levels while the quieter difference signal components have levels greater than their original levels.

The processing of the sum signal (L+R) is to raise the level of the sum signal so that it is not overwhelmed by the selective boosting of difference signal components.

The potentiometers 23, 27 are user controlled elements to allow the user to control the respective levels of the processed sum signal (L+R)ₚ and the processed difference signal (L-R)ₚ that are mixed by the mixer 25. For example, the potentiometers 23, 27 may be adjusted to minimize the processed difference signal and to maximize the processed sum signal. With such adjustment, the listener would hear primarily any center stage soloist present in the recording being played.

The left and right output signals Lₒᵤₜ and Rₒᵤₜ are provided to the sound perspective correction system 200 of the stereo enhancement system 300 of FIG. 1. Alternatively, as discussed relative to the stereo enhancement system 300 of FIG. 1 and to the extent that the sound perspective correction system 200 is not utilized, the left and right output signals Lₒᵤₜ and Rₒᵤₜ are appropriately provided, for example, to the tape monitor loop input of the preamplifier tape monitor loop that provided the left and right stereo signals L and R.

### B. The Feedback and Reverberation Control Circuit

Referring now to FIG. 3, shown therein is a block diagram of the feedback and reverberation control circuit 30 which includes a bandpass filter 32 that is responsive to the sum signal (L+R) and provides its output to an inverting peak detector 31. The output of the inverting peak detector 31 is an inverted sum signal envelope Eₛ. Preferably, the bandpass filter 32 has a - 3 dB bandwidth of 4.8 KHz located between 200 Hz and 5KHz and a roll-off of 6 dB per octave. The bandpass filter 32 filters out the effects of clicks and pops that may be present in recordings, and further filters out high energy low frequency components which would have an undersirable effect on the control signals provided by the control circuit 30. The time constants of the peak detector circuit 31 provide a rise time in the order of one millisecond and a decay time in the order of one-half second.

The feedback and reverberation control circuit 30 further includes a bandpass filter 34 that is responsive to the difference signal (L-R) and provides its output to a non-inverting peak detector 33. The output of the non-inverting peak detector 33 is a non-inverted difference signal envelope E_{d}. The bandpass filter 34 has characteristics similar to those of the bandpass filter 32 and has a -3 dB bandwidth of 4.8 KHz located between 200 Hz and 5 KHz, and a roll-off of 6 dB per octave. The time constants of the peak detector circuit 33 provide a rise time in the order of one millisecond and a decay time in the order of one-half second.

The feedback and reverberation control circuit 30 includes another bandpass filter 36 that is responsive to the processed difference signal (L-R)ₚ and provides its output to a non-inverting peak detector 35. The output of the non-inverting peak detector 35 is a non-inverted processed difference signal envelope E_{dp}. The bandpass filter 36 has characteristics similar to those of the bandpass filters 32, 34, and has a -3 dB passband of 4.8 KHz located between 200 Hz and 5 KHz and a roll-off of 6 dB per octave. The time constants of the peak detector 35 provide a rise time in the order of one millisecond and a decay time in the order of one-half second.

The outputs of the inverting peak detector 31 and the non-inverting peak detector 33 are respectively coupled to the fixed contacts of a potentiometer 37. As discussed more fully further herein, the signal available at the wiper contact of the potentiometer 37 is coupled to an averaging circuit 60 which provides the reverberation control signal RCTRL.

The output of the inverting peak detector 31 is further coupled to one fixed terminal of a potentiometer 39 which has its other fixed terminal coupled to ground. The inverted sum signal envelope Eₛ provided at the wiper contact of the potentiometer 39 is coupled via a summing resistor 41 to the summing junction 43 of an integrator 50. The non-inverted processed difference signal envelope E_{dp} provided by the non-inverting peak detector 35 is also coupled to the summing junction 43 via a summing resistor 45.

The integrator 50 further includes an operational amplifier 47 which has its inverting input connected to the summing junction 43 and has its non-inverting input connected to ground. An integrating capacitor 49 is connected between the output of the operational amplifier 47 and the summing junction 43. A zener clamp diode 51 is coupled between the output of the operational amplifier and the summing junction 43, and the functions to limit the maximum level of the control signal CTRL provided by the operational amplifier 47.

Further, the integrator 50 includes a zener diode 53 and a switch 55 serially coupled between the output of the operational amplifier 47 and the summing junction 43. The zener diode 53 has a value that is about in the middle of the output swing of the operational amplifier 47 as controlled by the zener clamp diode 51. The switch 55 is controlled by a difference signal detector 57 which is responsive to the difference signal envelope E_{d} provided by the peak detector 33. Specifically, the difference signal detector 57 controls the switch 55 to close and clamp the level of the integrator output CTRL when little or no difference signal envelope E_{d} is present. By way of example, the difference signal detector 57 may be a voltage comparator (or an operational amplifier biased as a voltage comparator) with an appropriate threshold reference near zero.

The switched clamp circuit including the zener diode 53 and the switch 55 prevent a substantial increase in the gain provided by the gain controlled amplifier 22 when the left and right input signals Lᵢₙ and Rᵢₙ contain very little or no stereo information. Without such a switched clamp circuit, left and right input signals containing very little or no stereo information would cause the integrator output CTRL to go to its maximum level since very little or no processed difference signal would be present. Such maximum level of the control signal CTRL would cause the gain controlled amplifier 22 to provide maximum gain, and when the input signals Lᵢₙ and Rᵢₙ subsequently contain stereo information, the processed difference signal would be dramatically amplified to the detriment of the audio equipment and listeners' comfort.

An alternative arrangement (not shown) of the switched clamp circuit 50 completely eliminates that one feedback path of amplifier 47 which includes zener diode 53 and switch 55. In such alternative arrangement, the switch 55 is connected between the summing junction 43 and the connection of the feedback path of capacitor 49, diode 51 to the inverting input to amplifier 47. The switch is still operated from the output of difference signal detector 57, which in this case, is connected to cause the switch to open when the difference signal detector 57 detects loss of the difference signal. Thus, with the loss of difference signal in such an alternative arrangement, the charge on integrating capacitor 49 remains frozen and, because the capacitor remains connected to the amplifier at all times, remains at the level existing upon the opening of the switch. Therefore the control signal from the output of amplifier 47 will not increase upon loss of the difference signal.

The output of the integrator 50 is the gain control signal CTRL and is indicative of the sum of (a) the inverted sum signal envelope Eₛ provided to the summing junction 43 and (b) the non-inverted processed difference signal envelope E_{dp} provided to the summing junction 43. The gain control signal CTRL is utilized to vary the gain applied to the difference signal (L-R) by the gain controlled amplifier 22 (FIG. 1) so that the sum of the sum and processed difference signal envelopes Eₛ, E_{dp} applied to the summing resistors 41, 45 of the integrator 50 tends toward zero. Thus, the non-inverted processed difference signal envelope E_{dp} provided to the summing junction 43 tends to inversely track or follow the inverted sum signal envelope Eₛ provided to the summing junction 43. Stated another way, the processed difference signal (L-R)ₚ is adjusted by the control signal CTRL in such a way that the non-inverted processed difference signal envelope E_{dp} tends to be equal and opposite to the inverted sum signal envelope Eₛ provided at the wiper contact of the potentiometer 39.

Referring to FIG. 2, the control circuit 30 and the gain controlled amplifier 22 in essence cooperate to maintain a predetermined ratio between the sum signal (L+R) provided by the summing circuit 13 and the processed difference signal (L-R)ₚ provided by the gain controlled amplifier 22. That predetermined ratio is set by the potentiometer 39 (FIG. 3).

As mentioned earlier, the averaging circuit 60 is responsive to the signal at the wiper contact of the potentiometer 37. The signal at the wiper contact of the potentiometer 37 is the sum of the inverted sum signal envelope Eₛ and the non-inverted difference signal envelope E_{d}, where the amount contributed by each envelope to the sum of envelopes is determined by the position of the wiper contact. Since the sum signal envelope is inverted and the difference signal is non-inverted, the sum of envelopes will tend to go to zero if the sum and difference envelopes at the wiper contact are close to being equal and opposite.

The averaging circuit 60 includes an operational amplifier 59 and an input resistor 61 coupled between the inverting input of the operational amplifier 59 and the wiper contact of the potentiometer 37. The non-inverting input of the operational amplifier 59 is connected to ground, and the output of the operational amplifier is the reverberation control signal RCTRL. A capacitor 63 and a resistor 65 are coupled in parallel between the output of the operational amplifier 59 and its inverting input. Effectively, the averaging circuit 60 is an integrator with a resistor coupled across the integrating capacitor.

So long as the sum of envelopes signal at the wiper contact of the potentiometer 37 is near zero, the reverberation control signal provided by the averaging circuit 60 is near zero. When the contribution of the sum signal envelope to the sum of envelopes signal at the wiper contact becomes predominant, the level of the reverberation control signal RCTRL increases. The predominance of the contribution of the sum signal, as determined by the setting of the potentiometer 37, indicates the possible presence of a center stage soloist, which in turn indicates the possibility of artificial reverberation in the difference signal.

In essence, the potentiometer 37 and the averaging circuit 60 cooperate to provide the reverberation control signal RCTRL when the ratio between (a) the inverted sum signal envelope Eₛ and (b) the non-inverted difference signal envelope E_{d} exceeds a predetermined value. That predetermined value is determined by the setting of the potentiometer 37. The reverberation control signal RCTRL is indicative of the amount by which that predetermined ratio is exceeded.

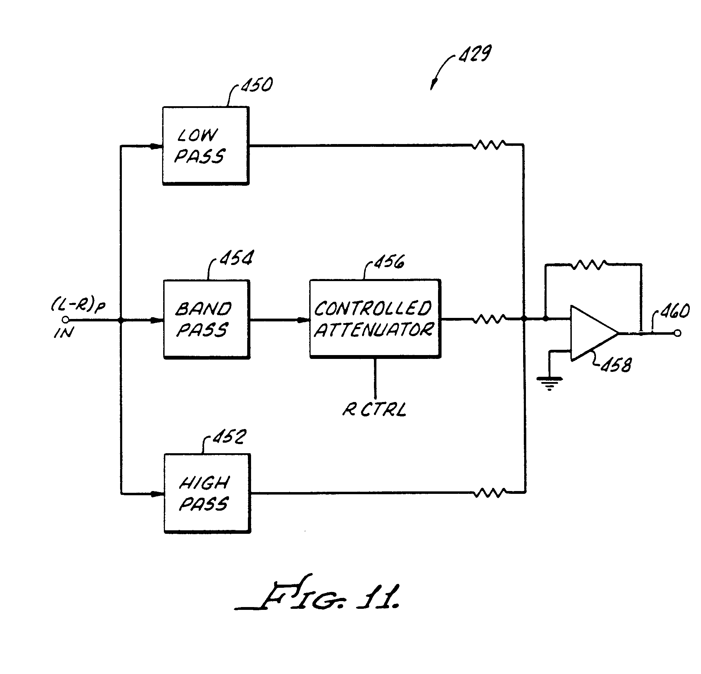

The reverberation control signal RCTRL provided at the output of the averaging circuit 60 is utilized to provide further controls to the reverberation bands (referenced previously in regard to FIG. 2 and centered at 500 Hz, 1 KHz, and 2 KHz) of the dynamic difference signal equalizer 19 and the dynamic sum signal equalizer 21. Specifically, the reverberation control signal RCTRL causes the dynamic difference signal equalizer 19 to provide further attenuation in the reverberation bands and causes the dynamic sum signal equalizer 21 to provide further boost in the reverberation bands. As mentioned previously, reverberation compensation of the processed sum signal may alternatively be achieved by selectively amplifying the output of the dynamic sum signal equalizer 21 with a gain controlled amplifier (not shown) pursuant to control by the reverberation control signal RCTRL. Such an arrangement is illustrated in FIG. 10 and described in detail below.

Since artificial reverberation is generally manifested in the difference signal components in the above-referenced reverberation bands, the further attenuation caused by the reverberation control signal RCTRL reduces the boost provided to any artificial reverberation that may be present. The further boost to the sum signal components in the reverberation bands is to compensate for any artificial reverberation which may not have been sufficiently attenuated by the dynamic difference signal equalizer 19.

Preferably, the potentiometer 37 is adjusted so that the sum of envelopes signal at the wiper contact is at a null or slightly biased toward the difference signal for input stereo signals that do not include a soloist.

It should be noted that the input to the averaging circuit 60 may alternatively be provided by other bandpass filter and peak detector circuitry, where each of such bandpass filters has a bandwidth which is more suitable to the detection of the possibility of the presence of reverberation.

In the foregoing stereo image enhancement system 10, automatic enhancement adjustment and reverberation compensation have been provided for the following reasons.

It has been determined that the amount of stereo information present in recordings varies considerably from recording to recording. For example, one recording may be close to being monaural while another may have "ping-pong" stereo where a sound source appears to move from side-to-side. As a result of the recording to recording variation in stereo information, and also such variation within a single recording, continual adjustment of the amount of enhancement may be required, and such adjustment is automatically and continually provided by the control circuit 30 and the gain controlled amplifier 22.

It has also been determined that recordings may include artificial acoustical or electronic reverberation, for example, for soloists featured at center stage. Such artificial reverberation is generally manifested in the difference signal (L-R). Analysis of a variety of recordings revealed that the primary energy of artificial reverberation is in the range between 250 Hz and 2500 Hz, particularly as to male and female vocalists. Such artificial reverberation may be a function of one or more of the vocal formants, possibly the first and/or second. See "The Acoustics of the Singing Voice," J. Sundberg, 1977, The Physics of Music, Scientific American, W.H. Freeman & Company.

When the processed difference signal (L-R)ₚ is increased for greater stereo enhancement, any artificial reverberation that may be present is also increased and may under some circumstances overwhelm the processed sum signal (L+R)ₚ. The presence of artificial reverberation is compensated by the control circuit 30 in cooperation with the selected reverberation bands of the difference signal equalizer 19 and the sum signal equalizer 21.

In the foregoing stereo image enhancement system 10, the sum signal equalizer 21 and the difference signal equalizer 19 are dynamically controlled by the spectrum analyzer 17, and in that sense the system is referred to as the dynamic stereo image enhancement system 10. Alternatively, a simplified non-dynamic equalization or fixed equalization stereo image enhancement system may be provided which does not include the spectrum analyzer 17 and which provides for fixed equalization of the sum and difference signals.

### C. The Fixed Stereo Image Enhancement System

Referring particularly to FIG. 4, shown therein is a block diagram of a statistical or fixed stereo image enhancement system 110 which includes a left input signal subsonic filter 112 and a right input signal subsonic filter 114 which are responsive to left and right stereo signals L and R provided by a stereo sound reproduction system (not shown). For example, as discussed above relative to the stereo enhancement system 300 of FIG. 1, the left and right stereo signals L and R may be provided by a preamplifier tape monitor loop output. The subsonic filters 112, 114 provide subsonically filtered input signals Lᵢₙ and Rᵢₙ to a summing circuit 111 and a difference circuit 113.

As discussed above relative to the dynamic stereo image enhancement system of FIG. 2, the subsonic filters 112, 114 afford protection against damage due to dropping a phono cartridge.

The difference circuit 111 subtracts the right signal Rᵢₙ from the left signal Lᵢₙ to provide a difference signal (L-R), and the summing circuit 113 adds the subsonically filtered left and right input signals Lᵢₙ and Rᵢₙ to provide a sum signal (L+R).

The difference signal (L-R) provided by the difference circuit 111 is provided to a fixed difference signal equalizer 115 which selectively attenuates the difference signal as a function of frequency. The fixed difference signal equalizer 115 is substantially similar to the fixed difference signal equalizer 18 of the dynamic stereo image enhancement system 10 of FIG. 2, and an appropriate equalization characteristic is shown in FIG. 5A. By way of example, the fixed difference signal equalizer 115 may include a plurality of parallel filter stages including a low pass filter and a high pass filter having the following characteristics. The low pass filter has a -3 dB frequency of about 200 Hz, a roll-off of 6 dB per octave, and a gain of unity. The high pass filter has a -3 dB frequency of about 7 KHz, a roll-off of 6 dB per octave, and a gain of one-half.

As discussed further herein, further amplification for the equalized difference signal output of the fixed difference equalizer 115 is provided by a gain controlled amplifier 125. Such amplification may also be provided, at least in part, by the fixed difference signal equalizer 115. The output of the gain controlled amplifier 125 is coupled to a reverberation filter 129 which provides a processed difference signal (L-R)ₚ as its output.

Referring again to FIG. 5A, it should be noted that the difference signal is particularly attenuated in the range of about 1 KHz to about 4 KHz since the human ear has greater sensitivity to such frequencies and since such frequency range includes difference signal components having wavelengths that are comparable to the distance between a listener's ears (the "frequencies of increased phase sensitivity"). As discussed previously and relative to the prior art, loud difference signals within such frequencies result in annoying harshness and limit a listener to being located equidistant between the speakers. By attenuating such frequencies, the harshness and the limitation on location are substantially reduced.

The sum signal (L+R) provided by the summing circuit 113 is coupled to a fixed sum signal equalizer 117. An appropriate equalization characteristic for the fixed sum signal equalizer 117 is shown in FIG. 5B. By way of example, the fixed sum signal equalizer 117 includes a bandpass filter which has -3 dB frequencies at 200 Hz and 7 KHz and rolls off at 6 dB per octave. The 200 Hz to 7 KHz bandwidth of the bandpass filter approximates the operating range of the dynamic sum signal equalizer 21 of the dynamic stereo image enhancement system 10 of FIG. 2.

It should be noted that the equalization characteristic of the fixed sum signal equalizer 117 rolls off below 200 Hz at 6 dB per octave to avoid overly emphasized bass. Moreover, there is very little difference signal in that range, so that the processed sum signal in that range does not have to be boosted very much.

As discussed further herein, further amplification of the processed sum signal (L+R)ₚ is provided by a gain controlled amplifier 127 which also provides for artificial reverberation compensation. Such amplification may also be provided, at least in part, by the fixed sum signal equalizer 117.

The equalization characteristics of the fixed equatizers 115, 117 and the gains associated with the processed sum and difference signals are intended to approximate the average behavior of the dynamic enhancement system 10 of FIG. 1 for a large variety of recordings. Thus, the difference signal components in the frequency ranges that statistically include predominantly quiet components are boosted relative to the difference signal components in the frequency ranges that statistically include predominantly louder components. The louder components of the difference signal are typically in the mid-range, and the quieter components are on either side of the mid-range. Particularly, the difference signal components in the mid-range are attenuated to a greater degree than the difference signal components on either side of the mid-range. The equalized signal is then boosted so that the difference signal components on either side of the mid-range are basted relative to the difference signal components in the mid-range.

The enhancement system 110 further includes a feedback and reverberation control circuit 40 which is substantially similar to the feedback and reverberation control circuit 30 of FIG. 3. The control circuit 40 cooperates with other elements in the system to provide for automatic adjustment of stereo enhancement and for reverberation compensation.

The control circuit 40 is responsive to the difference signal (L-R) provided by the difference circuit 111 and the sum signal (L+R) provided by the summing circuit 113. The control circuit 40 provides a gain control signal CTRL for controlling the gain controlled amplifier 125 which varies the gain applied to the equalized difference signal provided by the fixed difference signal equalizer 115. The control circuit 40 is further responsive to the amplified difference signal provided by the gain controlled amplifier 125. Particularly, the output of the gain controlled amplifier 125 would be provided to the bandpass filter 36 of the control circuit 30 of FIG. 3.

The control circuit 40 controls the gain controlled amplifier 125 so as to maintain a constant ratio between the sum signal (L+R) provided by the summing circuit 111 and the difference signal provided by the gain controlled amplifier 125.

The control circuit 40 further provides a reverberation control signal RCTRL to the gain controlled amplifier 127 which provides for reverberation compensation. By way of example, the gain controlled amplifier 127 may be an appropriate voltage controlled amplifier.

The reverberation filter 129 is a variable rejection filter that includes two one octave wide filters respectively centered at 500 Hz and 1.5 KHz, and each having a low Q to provide sufficient bandwidth. Each of the filters of the reverberation filter 129 may be similar to one of the equalizer bands in the dynamic difference signal equalizer 19 of the dynamic stereo image enhancement system 10 of FIG. 2, and provides a maximum attenuation of 12 dB for the maximum level of the reverberation control signal RCTRL. An alternative reverberation filter is shown in FIG. 11 and described below.

By way of example, the gain controlled amplifier 125 may be an appropriate voltage controlled amplifier. The processed sum signal (L+R)ₚ output of the gain controlled amplifier 127 is provided to a fixed terminal of a potentiometer 123 which has its other fixed terminal coupled to ground. The wiper contact of the potentiometer 123 is coupled to a mixer 121 which therefore receives the processed sum signal (L+R)ₚ having a level controlled by the potentiometer 123.

The processed difference signal (L-R)ₚ output of the reverberation filter 129 is coupled to a fixed terminal of a potentiometer 119 which has its other fixed terminal coupled to ground. The wiper contact of the potentiometer 119 is coupled to the mixer 121 which therefore receives the processed difference signal (L-R)ₚ having a level controlled by the potentiometer 119.

The gain controlled amplifier 127 and the reverberation filter 129 are preferably controlled by the reverberation control signal RCTRL so that the resulting increase in the processed sum signal (L+R) provided by the gain controlled amplifier 127 is less than the decrease in the processed difference signal (L-R)ₚ provided by the reverberation filter 129. Increasing the level of the processed sum signal (L+R)ₚ provided by the gain controlled amplifier 127 is to provide for a sufficient level of the processed sum signal (L+R)ₚ to compensate for any artificial reverberation not sufficiently attenuated by the reverberation filter 129.

The left and right subsonically filtered input signals Lᵢₙ and Rᵢₙ are provided as further inputs to the mixer 121. The mixer 121 combines the processed difference signal (L-R)ₚ and the processed sum signal (L+R)ₚ with the left and right input signals Lᵢₙ and Rᵢₙ to provide left and right output signals Lₒᵤₜ and Rₒᵤₜ. The mixer 121 may be similar to the mixer 25 of the dynamic stereo enhancement system 10 of FIG. 1, and would provide the left and right output signals Lₒᵤₜ, Rₒᵤₜ in accordance with the following:

${\text{L}}_{\text{out}} {\text{= L}}_{\text{in}} {\text{+ K₁(L+R)}}_{\text{p}} {\text{+ K₂(L-R)}}_{\text{p}} \text{(Equation 3)}$

${\text{R}}_{\text{out}} {\text{= R}}_{\text{in}} {\text{+ K₁(L+R)}}_{\text{p}} {\text{- K₂(L-R)}}_{\text{p}} \text{(Equation 4)}$

The value of K₁ is controlled by the potentiometer 123; and the value of K₂ is controlled by the potentiometer 119.

The potentiometers 119, 123 are user controlled elements to allow the user to control the levels of the processed difference signal (L-R)ₚ and the processed sum signal (L+R)ₚ that are mixed by the mixer 121. For example, the potentiometers 119, 123 may be adjusted to minimize the processed difference signal and to maximize the processed sum signal. With such adjustment, the listener would hear primarily any center stage soloist present in the recording being played.

The left and right output signals Lₒᵤₜ and Rₒᵤₜ are provided to the sound perspective correction system 200 of the stereo enhancement system 300 of FIG. 1 Alternatively, as discussed relative to FIG. 1, to the extent that the sound perspective correction system 200 is not utilized, the left and right output signals Lₒᵤₜ and Rₒᵤₜ are appropriately provided, for example, to the tape monitor loop input of the preamplifier that provided the left and right stereo signals L and R.

### D. The Perspective Correction System

The sound perspective correction system 210 of FIG. 6 provides perspective correction for (a) speakers located in front of the listener ("front located speakers"); (b) headphones; and (c) speakers located to the side of the listener ("side located speakers"), such as those in automobile doors. As used herein, the term headphones shall refer to all headphones, including those sometimes characterized as airline headsets. Generally, headphones can be categorized as being (a) circumaural where the earcup surrounds the entire large outer ear known as the pinna, (b) supraaural where the earcup sits on the outer surface of the pinna, and (c) intraaural where the earcup fits within the entrance to the ear canal.

Referring specifically to FIG. 6, the sound perspective correction system 210 includes a summing circuit 211 and difference circuit 213 which are both responsive to left and right input Lᵢₙ and Rᵢₙ signals provided by a stereo image enhancement system as described above or by a stereo sound reproduction system (not shown). For example, as discussed above relative to the stereo enhancement system 300 of FIG. 1, the left and right input signals Lᵢₙ and Rᵢₙ may be provided by the preamplifier tape monitor loop output of such a stereo system.

The summing circuit 211 adds the left and right input signals Lᵢₙ and Rᵢₙ to provide a sum signal (L+R), and the difference circuit 213 subtracts the right signal Rᵢₙ from the left signal Lᵢₙ to provide a difference signal (L-R).

The sum signal (L+R) is provided to the input of a fixed sum signal equalizer 215 which provides for one equalization output that is coupled to the switchable terminal 2 of a two-position switch 217. The switchable terminal 1 of the two-position switch 217 is coupled to the output of the summing circuit 211. The switched terminal of the switch 217 provides a switched sum signal (L+R)ₛ.

The difference signal (L-R) is provided to the input of a fixed difference signal equalizer 221 which provides for one equalization output that is coupled to the switchable terminal 1 of a two-position switch 223. The switch 223 is ganged together with the switch 217 so that each is in the same corresponding position. The switchable terminal 2 of the switch 223 is coupled to the output of the difference circuit 213. The switched terminal of the switch 223 provides a switched difference signal (L-R)ₛ. The ganged two-position switches 217, 223 are controlled by the user, and are set as a function of whether (a) front located speakers are to be used, or (b) headphones or side located speakers are to be used. It should be readily apparent that in position 1, the fixed sum signal equalizer 215 is bypassed, and in position 2 the fixed difference signal equalizer 221 is bypassed.

The switched terminal of the switch 217 is connected as an input to a mixer 225, and the switched terminal of the switch 223 is also connected as an input to the mixer 225. The mixer 225 combines the switched sum signal (L+R)ₛ and the switched difference signal (L-R)ₛ to provide left and right output signals Lₒᵤₜ and Rₒᵤₜ. Particularly, the left and right output signals Lₒᵤₜ and Rₒᵤₜ are provided by the mixer 225 in accordance with the following:

${\text{L}}_{\text{out}} {\text{=(L+R)}}_{\text{s}} {\text{+ (L-R)}}_{\text{s}} \text{(Equation 5)}$

${\text{R}}_{\text{out}} {\text{=(L+R)}}_{\text{s}} {\text{- (L-R)}}_{\text{s}} \text{(Equation 6)}$

Position 1 of the switches 217, 223 corresponds to sum and difference signals for use with front located speakers. Position 2 of the switches 217, 223 corresponds to sum and difference signals for use with headphones or side located speakers, such as in an automobile.

From the foregoing it should be evident that only the difference signal is equalized when front located speakers are utilized, and that only the sum signal is equalized when headphones or side located speakers are utilized.

Referring again to the fixed sum signal equalizer 215 and to the fixed difference signal equalizer 221, each includes a plurality of equalization bands which are about one-third octave wide. The following Tables I and II set forth the respective center frequencies of such equalizer bands and the amount of equalization provided.

Table I sets forth the equalization provided by the fixed difference signal equalizer 221 for the output connected to the switchable terminal 1 of the switch 223. As discussed above, the fixed sum signal equalizer 215 is bypassed when the switches 217, 223 are in position 1 (front speakers).

**TABLE I**

| Center Freq | Difference Signal Equalizer |
|---|---|
| 500 Hz | + 5.0 dB |
| 1 KHz | + 7.5 dB |
| 8 KHz | +15.0 dB |

Table II sets forth the equalization provided by the fixed sum signal equalizer 215 for the output connected to the switchable terminal 2 of the switch 217. As discussed above, the fixed difference signal equalizer 221 is bypassed when the switches 217, 223 are in position 2 (headphones or side speakers).

**TABLE II**

| Center Freq | Sum Signal Equalizer |
|---|---|
| 500 Hz | - 5.0 dB |
| 1 KHz | - 7.5 dB |
| 8 KHz | -15.0 dB |

The values set forth in Table I are representative values only and may be modified on the basis of factors including speaker location and speaker characteristics. Similarly, the values set forth in Table II are representative values only, and with side located speakers may be modified on the basis of factors including speaker location and speaker characteristics. With headphones, the values of Table II may also be modified on the basis of factors including the type of headphone, as well as specific headphone characteristics.

It should be noted that the equalization for headphones may differ from the equalization for side placed speakers. With side located speakers, the sound reaches the ear with little interference. However, with headphones, the combined structure of the headphones and the ear influences the spectrum of the sound reaching the eardrum. Moreover, the concha (the section leading into the ear canal) and part of the ear canal may be occluded by the headphone structure, which would further influence the spectrum of sound reaching the eardrum. A discussion of the effects of airline entertainment headsets on sound reproduction is set forth in "Some Factors Affecting the Performance of Airline Entertainment Headsets," S. Gilman, J. Audio Eng. Soc., Vol. 31, No. 12, December 1983, pp. 914-920.

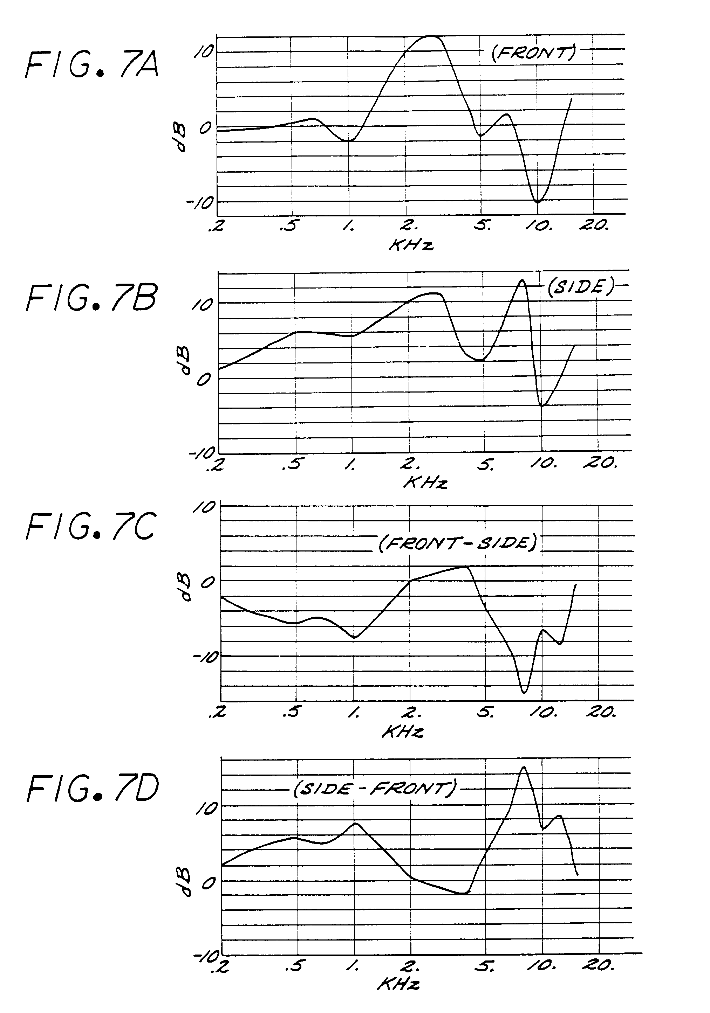

The equalization provided by the sound perspective control system 210 can be further understood by reference to FIGS. 7A through 7D. FIG. 7A represents a statistical average frequency response of the human ear to sound emanating from zero degrees azimuth or straight ahead (herein the "front response"). FIG. 7B represents a statistical average frequency response of the human ear for sound emanating from 90 degrees azimuth as measured relative to straight ahead (herein the "side response").

FIG. 7C is the front response relative to the side response, i.e., the response of FIG. 7A (front) minus the response of FIG. 7B (side). Equalization is required for sounds which should be emanating from the front but with side located speakers or headphones are emanating from the sides. The response of FIG. 7C is indicative of the equalization that would restore front sounds to their appropriate levels when such sounds are reproduced by side located speakers or headphones.

FIG. 7D is the side response relative to the front response, i.e., the response of FIG. 7B (side) minus the response of FIG. 7A (front) provides the response of FIG. 7D. Equalization is required for sounds which should be emanating from the sides but are emanating from the front. The response of FIG. 7D is indicative of the equalization that would restore side sounds to their appropriate levels when such sounds are reproduced by forward placed speakers.

The equalization characteristics of the equalizers 215, 221 are based on the response of FIGS. 7C and 7D, but do not provide the entire equalization indicated by such responses. It has been determined that equalization bands of one-third octave widths respectively centered at 500 Hz, 1 KHz, and 8 KHz are sufficient. The characteristics of each equalization band have been discussed previously.

The foregoing has been a disclosure of a stereo sound perspective correction system which provides for a stereo image having a corrected stereo sound perspective. It is readily utilized with or without the disclosed stereo image enhancement systems. Its use with a stereo image enhancement system would provide for a stereo image which is wider, a greater listening area when used with speakers, and proper sound perspective.

The disclosed implementation of the sound perspective correction system of the invention is not complex and effectively utilizes only a few narrow equalization bands. As discussed above, the relative responses of the front and side responses to one another tend to indicate that wider ranges of equalization should be utilized, but the few narrow equalization bands have been found to be a reasonable approximation over the entire audio bandwidth.

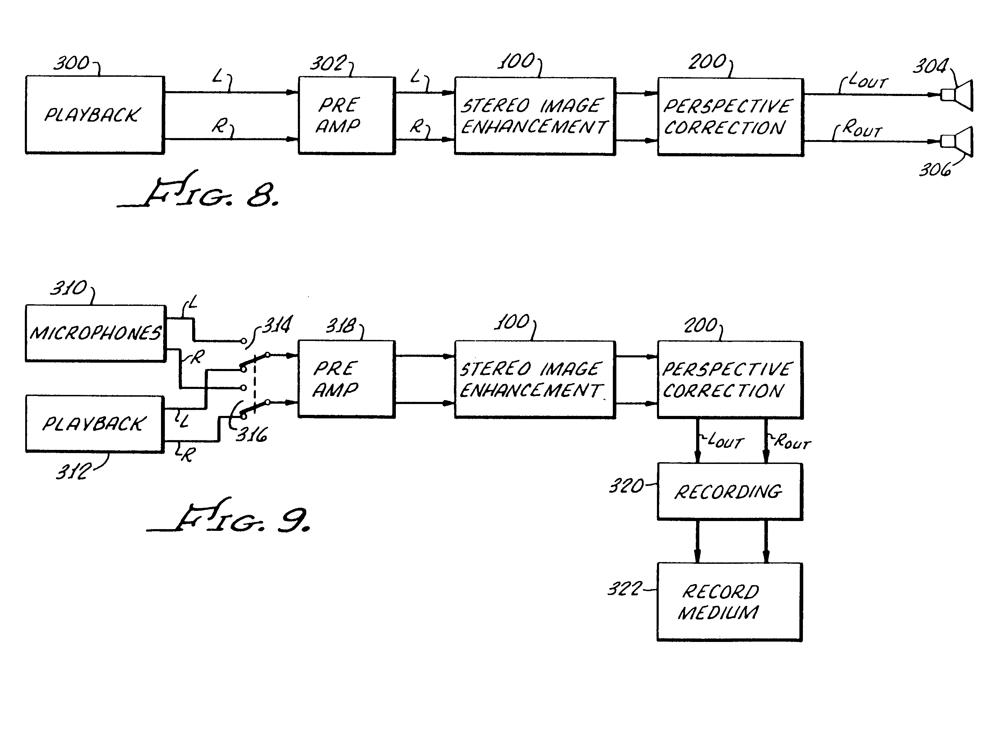

As previously mentioned, principles of the present invention are applicable either for playback of conventional stereo sound recordings or for the manufacture of unique stereo sound recordings which will provide advantages described above when played back through conventional sound responsive systems. Thus, as illustrated in Fig. 8, for playback of a conventional sound recording, an exemplary system having the enhancement described herein includes a conventional playback apparatus 300 which may respond to a digital record, such as a laser disc, a phonograph record, a magnetic tape, or the sound channel on video tape or motion picture film. The playback apparatus provides left and right channel stereo signals L,R to a preamplifier 302 from which the left and right signals are fed to the stereo image enhancement system 100 described above to provide processed output signals Lₒᵤₜ and Rₒᵤₜ fed either directly to a pair of conventional loudspeakers 304, 306 or fed to the speakers via the perspective correction system 200 previously described.

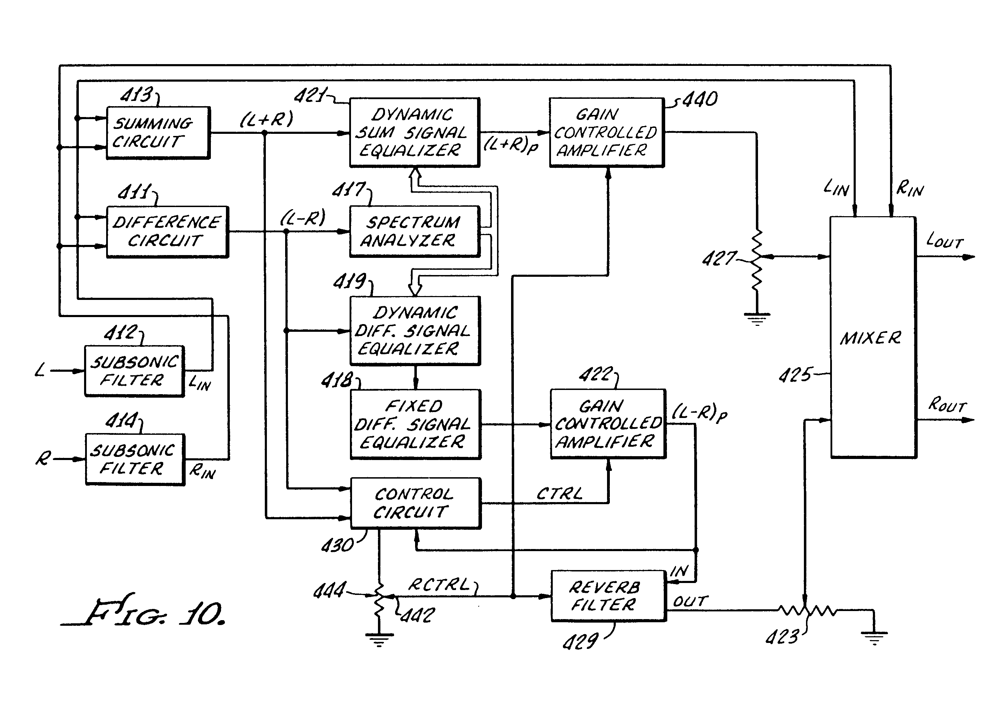

A similar arrangement is used in making a recording that will itself bear data in the form of physical grooves of a phonograph record, magnetic domains of a magnetic tape or like medium, or digital information that may be read by optical means. Such data defines left and right stereo signals formed of signal components that, when played back on a conventional sound reproducing system, produce all of the advantages described above. Thus, as illustrated schematically in Fig. 9, a recording system for making a sound recording embodying principles of the present invention may receive left and right stereo input signals from either a pair of microphones 310 or a conventional stereo playback system 312 which is adapted to provide left and right stereo input signals L,R. The playback system 312, like the system 300 of Fig. 8, may provide its output signals from any conventional record medium including digital records such as a laser disc, phonograph records, magnetic tape, or video or film sound track media.

Ganged switches 314, 316 schematically indicate in FIG. 9 that the system may use either left and right signals from a playback device or the left and right signals from a pair of microphones. These signals are fed to a preamplifier 318 and thence to the stereo image enhancement circuit 100 described above. From the stereo image enhancement circuit 100, the processed left and right output signals are fed either directly to a recording device 320 or indirectly to the recording device via the above described perspective correction circuit 200. The recording device conventionally records the left and right output signals Lₒᵤₜ and Rₒᵤₜ on a record medium 322 which may be any one of the record medium types commonly employed. It will be noted that the output signals Lₒᵤₜ and Rₒᵤₜ that are fed to recording device 320 are derived, in the case of the stereo image enhancement, from mixer 25 of Fig. 2 or mixer 21 of Fig. 4, or in the case of the perspective correction from the mixer 225 of Fig. 6.

The output signal Lₒᵤₜ recorded on the medium 322 includes the several left channel output signal components described, namely the described combination of ${\text{L}}_{\text{in}} {\text{+ K₁(L+R)}}_{\text{p}} {\text{+ K₂(L-R)}}_{\text{p}}$ for the left channel output. Similarly, the output signal Rₒᵤₜ is recorded upon the record medium by the recording apparatus and includes the components described above as

${\text{R}}_{\text{in}} {\text{+ K₁(L+R)}}_{\text{p}} {\text{-K₂(L-R)}}_{\text{p}} \text{.}$

The record medium 322, when recorded with the arrangement illustrated in Fig. 9, is simply played back on a conventional sound recording responsive device to provide the above-described advantages. These advantages are derived from the fact that the record medium so produced embodies signal-producing means that cooperates with the sound recording responsive device to produce left and right output signals that comprise a combination of signal components including a processed difference signal and a processed sum signal. The processed difference signal is a modification of an input difference signal formed in the stereo image enhancement circuit 100. This input difference signal represents the difference of the left and right input signals L and R, and as previously described, has relative amplitudes of certain components modified to boost those of its components that are within frequency bands wherein the input difference signal has lowest amplitude relative to those components of such input difference signal that are within frequency bands wherein the input difference signal components have highest amplitude. Similarly, the recording will produce a right stereo output signal component as a processed sum signal formed in the stereo image enhancement circuit 100. This processed sum signal component is a modification of the sum of the left and right channel input signals, and, as previously described, has relative amplitudes of certain components modified to boost those of its components in frequency bands where the input difference signal has higher amplitudes relative to those components of the input sum signal that are within frequency bands where the difference signal has lower amplitude. Thus, the record cooperates with the sound responsive system to cause the speakers to produce left and right stereo signals each having sum and difference components wherein amplitudes of such components are relatively attenuated or boosted, respectively, within those frequency bands wherein the difference signal has lower amplitudes. Moreover, the operation of the gain control amplifier 22 and control circuit 30 of Fig. 2, and the corresponding circuits of Fig. 4 cause the stereo output signals produced by playback of record 322 to have a substantially constant ratio of the sum signal to the modified or processed difference signal, all as previously described.

When the system of Fig. 9 is employed to make a record having perspective correction in addition to or instead of image enhancement, such a record will cooperate with the conventional stereo player to produce left and right stereo output signals having components including a processed sum signal which are increasingly attenuated in frequency bands centered on 500 Hz, 1 KHz and 8 KHz, respectively, as described above, and a component comprising a difference signal. Such a record is made specifically to be played back through a system including side mounted speakers. Where a perspective corrected record made with the system of FIG. 9 is specifically made for playback in a system with front mounted speakers, the record when played back on a stereo player will provide left and right stereo output signals wherein one output signal has components comprising a sum signal and a component comprising a difference signal, where such difference signal has amplitudes thereof increasingly boosted in frequency bands centered respectively at 500 Hz, 1 KHz and 8 KHz, as described above. Stated otherwise, the recording having perspective correction for front speakers, when played in a stereo player, produces a left output signal which is formed of the sum of a first component comprising the sum signal and a second component comprising the processed difference signal as set forth in equation 5 above and will provide a right output stereo signal formed of the difference between the sum signal and the processed difference signal as set forth in equation 6 above. When such a recording is made for use with side mounted speakers, only the sum signals in equations 5 and 6 are equalized whereas when the recording is made for use with front mounted speakers only the difference signals of equations of 5 and 6 are equalized.

It will be seen that a method of making unique stereo sound recordings having stereo image enhancement, or perspective correction, or both may be carried out by the apparatus illustrated in Fig. 9. The method generally comprises combining left and right input signals to generate sum and difference signals, and creating a processed sum signal by selectively altering relative amplitudes of components of the sum signal within respective predetermined frequency bands so as to boost those of the sum signal components which are within frequency bands of highest difference signal component amplitudes relative to those of the sum signal components which are within frequency bands of lowest difference signal component amplitudes. The method also includes the step of creating a processed difference signal by selectively alterating the relative amplitude of components of the difference signal within the predetermined frequency bands so as to attenuate those of the difference signal components which are within frequency bands where difference signal components are highest relative to those of the difference signal components which are within frequency bands wherein the difference signal components are lowest. The method also combines the left and right signals with the processed sum and difference signals to provide enhanced right and left output signals which are fed to a sound recording device to make a sound recording. Other features of the method include the described electronic analysis of the frequency spectrum of the difference signal and generation of control signals as a function of the amplitudes of the difference signal within respective predetermined frequency bands, and utilizing the control signals to determine the extent to which amplitudes of components of the sum and difference signals are altered within the respective frequency bands.

According to an important aspect of the method described herein, right and left signals are added and subtracted to generate sum and difference signals, a dynamic control signal is generated representing the amount of stereo in the input signals, the sum and difference signals are processed for enhancement of the output signals and at least one of the processed signals is modified in accordance with the amount of stereo in the input signals. A specific feature of this aspect of the method involves modification of one of the processed signals, which is accomplished so as to maintain a constant ratio between one of the sum and difference signals and the processed signal. In use of the described method, for making a recording that is corrected for perspective with side mounted speakers, left and right signals are combined to provide sum and difference signals, the sum signal is equalized as previously described and combined with the unprocessed difference signal to provide a left output formed of the sum of the processed sum signal and the unprocessed difference signal and to form a right output signal comprising the difference between the processed sum signal and the unprocessed difference signal. These output signals are fed to the recording mechanism to provide a record medium having perspective correction for side mounted speakers.

For front mounted speakers, a perspective corrected record medium is made by combining the right and left input signals to provide sum and difference signals, equalizing the difference signal as previously described, and combining the unprocessed sum signal with the equalized difference signal to provide a left output formed of the sum of the unprocessed sum signal and the processed or equalized difference signal and to provide a right output signal formed of the difference between the unprocessed sum signal and the equalized difference signal. These output signals are fed to a recording mechanism to produce a record medium having perspective correction for front speakers.

A record made by the apparatus and method described herein is uniquely distinguished from other stereo records in that unique signal generating data is embodied in the record. Whether such data is in the form of variable magnetic elements, varying grooves of a phonograph record or digital information such as variations in optical reflectivity of a laser or digital disc, for example, the unique aspects of such a record medium are readily recognizable. Upon playback of such an unique record by conventional record playing medium, stereo sound will be produced having all of the above-described advantages and composed of the specified signal components.

The amount of enhancement is continually and automatically adjusted by control circuit 30 and gain controlled amplifier 22 to compensate for variation in the amount of stereo information from one recording to another when using the described system for playback of conventional recordings. So too, such continuous and automatic adjustment is embodied in a recording made as indicated in Fig. 9. Thus, if the stereo information contained in a record employed in the playback system 312, or, if the stereo information reaching the microphone pair 310, should vary either from one recording to the next or should vary during any given performance or recording, the described control circuit 30 and gain control amplifier 22 will result in adjustment of the amount of enhancement in the information recorded on the record medium 322 and, therefore, result in such adjustment of output signals when record medium 322 is played back in a conventional system.

As described above and illustrated in FIG. 4, where fixed sum and difference equalizers are employed, amplitude of the processed sum channel signal is boosted, and certain frequencies of the processed difference signal are attenuated under control of the reverberation control signal RCTRL. This arrangement provides automatic control of the amount of reverberation by automatically increasing the level of the processed sum channel signal and concomitantly decreasing the level of certain frequencies of the difference channel signal. These increases and decreases in signal levels are effected in the reverberation bands, as described above, to reduce boost of natural or artificial reverberation that may be present, which boosts is provided by the enhancement circuits described herein. A similar reverberation control is also described above in connection with the arrangement illustrated in FIG. 2, in which the reverberation control signal is employed to cause the dynamic difference signal equalizer 19 to provide further attenuation in the reverberation bands and to cause the dynamic sum signal equalizer 21 to provide further boost to the sum signal components.

Reverberation control illustrated in FIG. 2 may be considerably improved by providing an automatic reverberation control through the use of a gain controlled amplifier in the sum channel and an attenuating reverberation filter in the difference channel. Such an improved arrangement is illustrated in FIG. 10, which shows a system substantially similar to that illustrated in FIG. 2, having many of the same components. Components which are the same in both FIGS. 2 and 10 are designated by the same reference numerals with the corresponding components of FIG. 10 having the prefix "4" so that for example, summing circuit 13 of FIG. 2 is the same as summing circuit 413 of FIG. 10. The arrangement of FIG. 10 differs from that of FIG. 2 generally by providing an automatically and manually controllable reverberation control signal, which is employed to control a gain controlled sum channel amplifier 440, and the addition of a reverberation signal controlled reverberation filter 429 (analogous to reverberation filter 129 of the fixed equalizer arrangement of FIG. 4) to handle the processed difference signal. In the circuit of FIG. 10 the tendency of the described enhancement circuits to provide excessive emphasis of reverberation in the inputs is automatically and selectively restrained.

Control circuit 430 is identical to the control circuit illustrated in FIG. 3 but the reverberation signal, RCTRL, provided from this circuit is derived from the manually adjustable wiper arm 442 of a reverberation control potentiometer 444, to which is fed the reverberation control signal from the output of amplifier 59 of FIG. 3. The reverberation control signal from wiper 442 is fed to control the gain of the gain controlled amplifier 440 to which is fed the output (L + R)ₚ of dynamic sum signal equalizer 421. The output of gain controlled amplifier 440 is fed to a potentiometer 427 for input to the mixer 425, just as described in connection with the output of dynamic sum signal equalizer 21 of FIG. 2. In this case the reverberation control signal is not fed to the dynamic difference signal equalizer nor to the dynamic sum signal equalizer directly.

The processed difference signal from the output of gain controlled amplifier 422 is fed to the input of a reverberation filter 429 of which the output is fed to potentiometer 423 and thence to mixer 425 just as described in connection with the output of the gain controlled amplifier 22 of FIG. 2.

The reverberation filter 429 may be the same as reverberation filter 129 illustrated in FIG. 4. However, it is presently preferred to employ a reverberation filter arranged as illustrated in FIG. 11, which is basically a variable attenuation band reject filter. As illustrated in FIG. 11, the processed difference signal (L-R)ₚ is fed to the filter input and thence in parallel to a lowpass filter 450, a highpass filter 452, and a bandpass filter 454. The output of the bandpass filter 454 is fed to a controlled attenuating circuit 456 having the reverberation control RCTRL as its controlling input. The three outputs, from filters 450 and 452 and from the attenuator 456, are combined and fed to the inverting input of a differential amplifier 458 having its noninverting input grounded, thus providing at its output 450 the gain controlled and reverberation filter controlled processed difference signal to be fed to the potentiometer 423. The filter sections of the reverberation filter 429 collectively provide a lowpass up to about 250 hertz, a highpass above about 4 kilohertz, and a controlled attenuation bandpass between about 400 hertz and 2.5 kilohertz.

Therefore, in a manner similar to the operation of the fixed equalization arrangement of FIG. 4, the circuit of FIG. 10 provides for sensing of the amount of reverberation, whether natural or artificial, in the input signals and provides a reverberation control signal RCTRL based upon such sensed reverberation. The control signal RCTRL boosts the processed sum signal and attenuates a frequency band of the processed difference signal so as to automatically control the effect of the described enhancement system on the amount of reverberation in the input signal. The automatic control of reverberation is manually selectable by manual control of the potentiometer 444, a feature that is of great importance in the recording industry. Close selective adjustment of the amount of reverberation is required in making a recording, and in particular in making a new or re-recording of an old recording. Thus any undesired enhancement of reverberation that may be introduced by the described enhancement circuitry is readily avoided by the automatic control of both sum and difference channels and by the manually selectable control of the level of the reverberation control signal itself. Of course the manual control of the level of the reverberation control signal as illustrated in FIG. 10 may be readily applied to obtain manual control of the level of the reverberation control signal RCTRL shown in the circuit of FIG. 4, which is fed to control the reverberation filter 129.

Overall, the foregoing has been a disclosure of systems for substantially improving the stereo image resulting from recorded performances, both in playback of conventional records and in the production of improved recordings. Such systems are readily utilized with standard audio equipment and are readily added to installed audio equipment. Further, the disclosed systems may be easily incorporated into preamplifiers and/or integrated amplifiers. Such incorporation may include provisions for bypassing the disclosed systems.

The disclosed stereo enhancement system is readily implemented using analog techniques, digital techniques, or a combination of both. Further, the disclosed stereo enhancement system is readily implemented with integrated circuit techniques.

Also, the disclosed systems may be utilized with or incorporated into a variety of audio systems including airline entertainment systems, theater sound systems, recording systems for producing recordings which include image enhancement and/or perspective correction, and electronic musical instruments such as organs and synthesizers.

Further, the disclosed systems would be particularly useful in automotive sound systems, as well as sound systems for other vehicles such as boats.

It will of course be understood that the present invention has been described above purely by way of example, and modifications of detail can be made within the scope of the invention.

## Claims

1. Apparatus for modifying stereo sum (L+R) and difference (L-R) signals derived from left (L) and right (R) stereo input signals to produce left (Lₒᵤₜ) and right (Rₒᵤₜ) stereo output signals, characterised by:-
processing means (17,18,19,21,22,30; 40,115,117,125,127) responsive to said sum and difference signals for selectively altering the relative amplitudes of frequency components of said difference signal such that louder frequency components of said difference signal are attenuated relative to quieter frequency components of said difference signal, thereby providing a processed difference signal (L-R)ₚ, and for selectively altering the relative amplitudes of frequency components of said sum signal such that selected sum signal components are boosted relative to other sum signal components, thereby providing a processed sum signal (L+R)ₚ, and
means (25; 121) responsive to said processed sum and difference signals to provide left (Lₒᵤₜ) and right (Rₒᵤₜ) stereo output signals.

2. Apparatus according to Claim 1 wherein said processing means includes equalizing means (115) for selectively altering the relative amplitudes of frequency components of said difference signal (L-R) such that components at frequencies that statistically include louder components are attenuated relative to components at frequencies that statistically include quieter components.

3. Apparatus according to Claim 2 wherein said processing means includes a further equalizing means (117) for selectively altering the relative amplitudes of frequency components of said sum signal (L+R) such that components within a predetermined frequency range that statistically includes louder difference signal components are relatively boosted, and components outside said predetermined frequency range are relatively attenuated.

4. Apparatus according to Claim 3 wherein said equalizing and further equalizing means respectively include a first fixed equalizer (115) and a second fixed equalizer (117).

5. Apparatus according to Claim 1 wherein said processing means includes analytical means (17) for analyzing the frequency spectrum of said difference signal (L-R) and for generating control signals as a function of the amplitudes of frequency components of said difference signal within respective predetermined frequency bands, and utilizing means (19) for utilizing said control signals to determine the extent to which the amplitudes of components of said difference signal are altered within said respective frequency bands.

6. Apparatus according to Claim 5 wherein said processing means is adapted to selectively alter the relative amplitudes of frequency components of said sum signal (L+R) within said respective predetermined frequency bands such that components within frequency bands of louder difference signal components are boosted relative to components within frequency bands of quieter difference signal components, and includes a further utilizing means (21) for utilizing said control signals to determine the extent to which the amplitudes of components of said sum signal are altered within said respective frequency bands.

7. Apparatus according to any of the preceding claims including control means (30; 40) for amplifying said processed difference signal as a function of its magnitude relative to that of said sum signal to provide a substantially consistent stereo image for differing amounts of stereo information within said left and right stereo input signals.

8. Apparatus according to any of the preceding claims including means (30; 40) for monitoring the relative magnitudes of said sum and difference signals to detect conditions indicative of the presence of artificial reverberation, and for modifying said processed difference signal to compensate for effects of artificial reverberation.

9. Apparatus for making a stereo sound recording comprising an apparatus according to any of the preceding claims, and a sound recording device coupled to receive said left (Lₒᵤₜ) and right (Rₒᵤₜ) stereo output signals for making a sound recording.

10. A method of modifying left (L) and right (R) stereo source signals, said method comprising the steps of:
(a) electronically adding said left and right signals so as to generate a sum signal (L+R), and electronically subtracting one of said left and right signals from the other to generate a difference signal (L-R);
characterised by the further steps of:
(b) creating a processed difference signal (L-R)ₚ by selectively altering the relative amplitudes of frequency components of said difference signal such that louder frequency components of said difference signal are attenuated relative to quieter frequency components of said difference signal;
(c) creating a processed sum signal (L+R)ₚ by selectively altering the relative amplitudes of frequency components of said sum signal such that selected sum signal components are boosted relative to other sum signal components; and
(d) combining said left and right stereo source signals with said processed difference signal, and with said processed sum signal to provide modified stereo left (Lₒᵤₜ) and right (Rₒᵤₜ) output signals.

11. A method according to Claim 10 wherein said steps of creating processed difference and sum signals are augmented by the step of analyzing the frequency spectrum of said difference signal and generating control signals as a function of the amplitudes of frequency components of said difference signal within respective predetermined frequency bands, and utilizing said control signals to determine the extent to which the amplitudes of components of said difference and sum signals are altered within said respective frequency bands.

12. A method according to Claim 10 or 11 including the additional step of continually and automatically amplifying said processed difference signal as a function of its magnitude relative to that of said sum signal so as to maintain a substantially consistent stereo separation between said left and right signals for differing amounts of stereo information within said left and right stereo source signals.

13. A method according to Claim 12 wherein said step of continually and automatically amplifying is accomplished by averaging the sum of (a) the inverted peak envelope of said sum signal, and (b) the non-inverted peak envelope of said difference signal so as to generate a reverberation control signal, and boosting and attenuating components of said sum and difference signals, respectively, as a function of said reverberation control signal.

14. A method according to any of Claims 10 to 13 wherein said step of creating a processed difference signal boosts artificial reverberation information in said difference signal, and including the additional step of selectively boosting components of said sum signal, and selectively attenuating components of said difference signal within selected frequency bands in order to compensate for inappropriate boosting of artificial reverberation information in said difference signal.

15. A method according to any of Claims 10 to 14 wherein the step of creating a processed sum signal is performed by selectively boosting said sum signal components in given frequency bands in direct proportion to the magnitude of said difference signal components in said given frequency bands.

16. A method according to any of Claims 10 to 15 wherein the step of creating a processed difference signal is performed by selectively boosting said difference signal components in given frequency bands in inverse proportion to the magnitude of said difference signal components in said given frequency bands.

17. A medium on which a stereo sound recording has been recorded, the medium being adapted to provide stereo left (Lₒᵤₜ) and right (Rₒᵤₜ) output signals which are modifications of left (L) and right (R) stereo source signals, characterised by:
(a) said left output signal (Lₒᵤₜ) having:
1. a left stereo source signal component (L),
2. a processed difference signal component (L-R)ₚ that comprises an input difference signal representing the difference between left and right stereo source signals modified such that louder frequency components of said input difference signal are attenuated relative to quieter frequency components of said input difference signal, and
3. a processed sum signal component (L+R)ₚ that comprises an input sum signal representing the sum of left and right stereo source signals modified such that selected input sum signal components are boosted relative to other input sum signal components,
(b) said right output signal (Rₒᵤₜ) having:
1. a right stereo source signal component (R),
2. a processed difference signal component (L-R)ₚ that comprises an input difference signal representing the difference between left and right stereo source signals modified such that louder frequency components of said input difference signal are attenuated relative to quieter frequency components of said input difference signal, and
3. a processed sum signal component (L+R)ₚ that comprises an input sum signal representing the sum of left and right stereo source signals modified such that selected input sum signal components are boosted relative to other input sum signal components.

18. A medium according to claim 17 wherein the ratio of amplitudes of one of said input sum and difference signals to one of said processed sum and difference signal components is substantially constant.

19. A medium according to claim 17 or 18 wherein said processed difference signal component has a value that varies with variation of the ratio between said input sum signal and said processed difference signal component.

20. A medium according to claim 17, 18 or 19 wherein said input sum signal and said input difference signal have components thereof in selected frequency bands altered to compensate for effects of artificial reverberation.

21. A method of making a stereo sound recording from left (L) and right (R) stereo source signals, wherein the sum of the left and right stereo source signals is provided as a sum signal (L+R) and the difference between the left and right stereo source signals is provided as a difference signal (L-R), characterised by:
(a) creating a processed difference signal (L-R)ₚ by selectively altering the relative amplitudes of frequency components of said difference signal such that louder frequency components of said difference signal are attenuated relative to quieter frequency components of said difference signal;
(b) creating a processed sum signal (L+R)ₚ by selectively altering the relative amplitudes of frequency components of said sum signal such that selected sum signal components are boosted relative to other sum signal components;
(c) combining said left and right stereo source signals with said processed difference signal, and with said processed sum signal to provide modified stereo left (Lₒᵤₜ) and right (Rₒᵤₜ) output signals; and
(d) operating a sound recording device (320) in response to said modified stereo left and right output signals to make a sound recording (322).

22. A method according to claim 21 including the additional step of continually and automatically amplifying one of said processed sum and difference signals as a function of its magnitude relative to that of one of said sum and difference signals so as to maintain a substantially consistent stereo separation between said left and right signals for differing amounts of stereo information within said left and right stereo source signals.

23. A method according to claim 21 or 22 wherein said step of creating a processed difference signal boosts artificial reverberation information in said difference signal, and including the additional step of selectively boosting components of said sum signal, and selectively attenuating components of said difference signal within selected frequency bands in order to compensate for inappropriate boosting of artificial reverberation information in said difference signal.

24. A method according to claim 21, 22 or 23, characterised by recording the modified stereo left (Lₒᵤₜ) and right (Rₒᵤₜ) output signals derived by a method according to any of claims 10 to 16.

25. A method according to any of claims 10 to 16 or 24, wherein the modified stereo left (Lₒᵤₜ) and right (Rₒᵤₜ) output signals are derived from the left (L) and right (R) signals of a stereo sound system.

26. An electronic stereo signal of a stereo sound recording, the stereo signal comprising stereo left (Lₒᵤₜ) and right (Rₒᵤₜ) output signals which are modifications of left (L) and right (R) stereo source signals, characterised by:
(a) said left output signal (Lₒᵤₜ) having:
1. a left stereo source signal component (L),
2. a processed difference signal component (L-R)ₚ that comprises an input difference signal representing the difference between left and right stereo source signals modified such that louder frequency components of said input difference signal are attenuated relative to quieter frequency components of said input difference signal, and
3. a processed sum signal component (L+R)ₚ that comprises an input sum signal representing the sum of left and right stereo source signals modified such that selected input sum signal components are boosted relative to other input sum signal components,
(b) said right output signal (Rₒᵤₜ) having:
1. a right stereo source signal component (R),
2. a processed difference signal component (L-R)ₚ that comprises an input difference signal representing the difference between left and right stereo source signals modified such that louder frequency components of said input difference signal are attenuated relative to quieter frequency components of said input difference signal, and
3. a processed sum signal component (L+R)ₚ that comprises an input sum signal representing the sum of left and right stereo source signals modified such that selected input sum signal components are boosted relative to other input sum signal components.

27. A stereo signal according to claim 26 wherein the ratio of amplitudes of one of said input sum and difference signals to one of said processed sum and difference signal components is substantially constant.

28. A stereo signal according to claim 26 or 27, wherein said processed difference signal component has a value that varies with variation of the ratio between said input sum signal and said processed difference signal component.

29. A stereo signal according to claim 26, 27 or 28 wherein said input sum signal and said input difference signal have components thereof in selected frequency bands altered to compensate for effects of artificial reverberation.

## Patentansprüche

1. Vorrichtung zur Modifizierung von Stereosummen- (L+R) und Differenzsignalen (L-R), welche herrühren von linken (L) und rechten (R) Stereoeingangssignalen, um linke (Lₒᵤₜ) und rechte (Rₒᵤₜ) Stereoausgangssignale zu erzeugen, gekennzeichnet durch
Verfahrensmittel (17, 18, 19, 21, 22, 30; 40, 115, 117, 125, 127), welche auf die Summen- und Differenzsignale zum selektiven Verändern der relativen Amplituden von Frequenzkomponenten des Differenzsignals ansprechen, so daß lautere Frequenzkomponenten des Differenzsignals relativ zu ruhigeren Frequenzkomponenten des Differenzsignals abgeschwächt werden, wodurch ein verarbeitetes Differenzsignal (L-R)ₚ bereitgestellt wird, und zum selektiven Verändern der relativen Amplituden der Frequenzkomponenten des Summensignals, so daß ausgewählte Summensignalkomponenten relativ zu anderen Summensignalkomponenten verstärkt werden, wodurch ein verarbeitetes Summensignal (L+R)ₚ bereitgestellt wird, und
Mittel (25; 121), welche auf die verarbeiteten Summen- und Differenzsignale ansprechen, um linke (Lₒᵤₜ) und rechte (Rₒᵤₜ) Stereoausgangssignale bereitzustellen.

2. Vorrichtung nach Anspruch 1, worin das Verfahrensmittel Entzerrmittel (115) zum selektiven Verändern der relativen Amplituden von Frequenzkomponenten des Differenzsignals (L-R) beinhalten, so daß Komponenten bei Frequenzen, welche statistisch lautere Komponenten beinhalten, relativ zu Komponenten bei Frequenzen abgeschwächt werden, welche statistisch ruhigere Komponenten beinhalten.

3. Vorrichtung nach Anspruch 2, worin das Verfahrensmittel ein weiteres Entzerrmittel (117) zum selektiven Verändern der relativen Amplituden von Frequenzkomponenten des Summensignals (L+R) beinhaltet, so daß Komponenten innerhalb eines vorherbestimmten Frequenzbereiches, welcher statistisch lautere Differenzsignalkomponenten beinhaltet, relativ verstärkt werden, und Komponenten außerhalb des vorherbestimmten Frequenzbereichs relativ abgeschwächt werden.

4. Vorrichtung nach Anspruch 3, worin das Entzerr- und das weitere Entzerrmittel jeweils einen ersten festgelegten Entzerrer (115) und einen zweiten festgelegten Entzerrer (117) enthalten.

5. Vorrichtung nach Anspruch 1, worin das Verfahrensmittel analytische Mittel (17) zum Analysieren des Frequenzspektrums des Differenzsignals (L-R) und zum Erzeugen von Steuersignalen als Funktion der Amplituden von Frequenzkomponenten des Differenzsignals innerhalb jeweiliger vorherbestimmter Frequenzbänder beinhaltet, und Verwendungsmittel (19) zur Verwendung der Steuersignale, um den Umfang zu bestimmen, zu welchem die Amplituden der Komponenten des Differenzsignals innerhalb der jeweiligen Frequenzbänder verändert werden.

6. Vorrichtung nach Anspruch 5, worin das Verfahrensmittel angepaßt ist, um die relativen Amplituden von Frequenzkomponenten des Summensignals (L+R) innerhalb der jeweiligen vorherbestimmten Frequenzbänder selektiv zu verändern, so daß Komponenten innerhalb von Frequenzbändern von lauteren Differenzsignalkomponenten relativ zu Komponenten innerhalb von Frequenbändern von ruhigeren Differenzsignalkomponenten verstärkt werden, und ein weiteres Verwendungsmittel (21) zur Verwendung der Steuersignale beinhaltet, um den Umfang zu bestimmen, zu welchem die Amplituden von Komponenten des Summensignals innerhalb der jeweiligen Frequenzbänder verändert werden.

7. Vorrichtung nach irgendeinem der vorangehenden Ansprüche, welche eine Steuervorrichtung (30; 40) zum Verstärken des verarbeiteten Differenzsignals als Funktion seiner Größe relativ zu der des Summensignals beinhaltet, um ein im wesentlichen konsistentes Stereobild für unterschiedliche Beträge von Stereoinformationen innerhalb der linken und rechten Stereoeingangssignale bereitzustellen.

8. Vorrichtung nach irgendeinem der vorangehenden Ansprüche, welche Mittel (30; 40) zur Überwachung der relativen Größen der Summen- und Differenzsignale beinhaltet, um Bedingungen festzustellen, welche die Gegenwart von künstlichem Nachhall anzeigen, und zum Modifizieren des verarbeiteten Differenzsignals, um Effekte künstlichen Nachhalls zu kompensieren.

9. Vorrichtung zum Erzeugen einer Stereotonaufzeichnung mit einer Vorrichtung nach irgendeinem der vorangehenden Ansprüche, und einem tonaufzeichnendem Bauteil, welcher gekoppelt ist, um die linken (Lₒᵤₜ) und rechten (Rₒᵤₜ) Stereoausgangssignale zum Erzeugen einer Tonaufzeichnung zu empfangen.

10. Ein Verfahren von Modifizierung linker (L) und rechter (R) Stereoquellsignale, wobei das Verfahren die Schritte aufweist:
(a) elektronisches Addieren der linken und rechten Signale, um ein Summensignal (L+R) zu erzeugen, und elektronisches Substrahieren eines der linken und rechten Signale voneinander, um ein Differenzsignal (L-R) zu erzeugen;
gekennzeichnet durch die weiteren Schritte:
(b) Erzeugen eines verarbeiteten Differenzsignals (L-R)ₚ durch selektives Verändern der relativen Amplituden von Frequenzkomponenten des Differenzsignals, so daß lautere Frequenzkomponenten des Differenzsignals relativ zu ruhigeren Frequenzkomponenten des Differenzsignals abgeschwächt werden;
(c) Erzeugen eines verarbeiteten Summensignals (L+R)ₚ durch selektives Verändern der relativen Amplituden von Frequenzkomponenten des Summensignals, so daß ausgewählte Summensignalkomponenten relativ zu anderen Summensignalkomponenten verstärkt werden; und
(d) Kombinieren der linken und rechten Stereoquellsignale mit dem verarbeiteten Differenzsignal, und mit dem verarbeiteten Summensignal, um modifizierte linke (Lₒᵤₜ) und rechte (Rₒᵤₜ) Stereoausgangssignale bereitzustellen.

11. Ein Verfahren nach Anspruch 10, worin die Schritte des Erzeugens von Differenz- und Summensignalen vermehrt werden durch den Schritt des Analysierens des Frequenzspektrums des Differenzsignals und Erzeugen von Steuersignalen als Funktion der Amplituden von Frequenzkomponenten des Differenzsignals innerhalb jeweiliger vorherbestimmter Frequenzbänder, und Verwenden der Steuersignale, um den Umfang zu bestimmen, zu dem die Amplituden von Komponenten der Differenz- und Summensignale innerhalb der jeweiligen Frequenzbänder verändert werden.

12. Ein Verfahren nach Anspruch 10 oder 11, welches den zusätzlichen Schritt des kontinuierlichen und automatischen Verstärkens des verarbeiteten Signals als Funktion seiner Größe relativ zu der des Summensignals beinhaltet, um eine im wesentlichen konsistente Stereotrennung zwischen den linken und rechten Signalen für unterschiedliche Umfänge von Stereoinformation innerhalb der linken und rechten Stereoquellsignale beizubehalten.

13. Ein Verfahren nach Anspruch 12, worin der Schritt des kontinuierlichen und automatischen Verstärkens durch Mittelung der Summe von (a) der invertierten Spitzeneinhüllenden des Summensignals und (b) der nichtinvertierten Spitzeneinhüllenden des Differenzsignals erreicht wird, um ein Nachhallsteuersignal zu erzeugen, und Verstärken und Abschwächen von Komponenten jeweils der Summen- und Differenzsignale als Funktion des Nachhallsteuersignals.

14. Ein Verfahren nach irgendeinem der Ansprüche 10 bis 13, worin der Schritt des Erzeugens eines verarbeiteten Differenzsignals die künstliche Nachhallinformation in dem Differenzsignal verstärkt, und welches den zusätzlichen Schritt selektiven Verstärkens von Komponenten des Summensignals, und selektiven Abschwächens von Komponenten des Differenzsignals innerhalb ausgewählter Frequenzbänder beinhaltet, um ungeeignetes Verstärken von künstlicher Nachhallinformation in dem Differenzsignal zu kompensieren.

15. Ein Verfahren nach irgendeinem der Ansprüche 10 bis 14, worin der Schritt des Erzeugens eines verarbeiteten Summensignals durch selektives Verstärken der Summensignalkomponenten in gegebenen Frequenzbändern in direkter Proportion zu der Größe der Differenzsignalkomponenten in den gegebenen Frequenzbändern durchgeführt wird.

16. Ein Verfahren nach irgendeinem der Ansprüche 10 bis 15, worin der Schritt des Erzeugens eines verarbeiteten Differenzsignals durch selektives Verstärken der Differenzsignalkomponenten in gegebenen Frequenzbändern in umgekehrter Proportion zu der Größe der Differenzsignalkomponenten in den gegebenen Frequenbändern durchgeführt wird.

17. Ein Medium, auf welchem eine Stereotonaufzeichnung aufgezeichnet worden ist, wobei das Medium angepaßt ist, um linke (Lₒᵤₜ) und rechte (Rₒᵤₜ) Stereoausgangssignale bereitzustellen, welche Modifikationen von linken (L) und rechten (R) Stereoquellsignalen sind, gekennzeichnet durch:
(a) das linke Ausgangssignal (Lₒᵤₜ) mit:
1. einer linken Stereoquellsignalkomponente (L),
2. einer verarbeiteten Differenzsignalkomponente (L-R)ₚ, welche ein Eingangsdifferenzsignal umfaßt, das den Unterschied zwischen linken und rechten Stereoquellsignalen repräsentiert, welche modifiziert sind, so daß lautere Frequenzkomponenten des Eingangsdifferenzsigals relativ zu ruhigeren Frequenzkomponenten des Eingangsdifferenzsignals abgeschwächt werden, und
3. einer verarbeiteten Summensignalkomponente (L+R)ₚ, welche ein Eingangssummensignal umfaßt, das die Summe der linken und rechten Stereoquellsignale repräsentiert, welche modifiziert sind, so daß ausgewählte Eingangssummensignalkomponenten relativ zu anderen Eingangssummensignalkomponenten verstärkt werden,
(b) das rechte Ausgangssignal (Rₒᵤₜ) mit:
1. einer rechten Stereoquellsignalkomponente (R),
2. einer verarbeiteten Differenzsignalkomponente (L-R)ₚ, welche ein Eingangsdifferenzsignal umfaßt, das die Differenz zwischen den linken und rechten Stereoquellsignalen repräsentiert, welche modifiziert sind, so daß lautere Frequenzkomponenten des Eingangsdifferenzsignals relativ zu ruhigeren Frequenzkomponenten des Eingangsdifferenzsignals abgeschwächt werden, und
3. einer verarbeiteten Summensignalkomponente (L+R)ₚ, welche ein Eingangssummensignal umfaßt, das die Summe der linken und rechten Stereoquellsignale repräsentiert, welche modifiziert sind, so daß ausgewählte Eingangssummensignalkomponenten relativ zu anderen Eingangssummensignalkomponenten verstärkt werden.

18. Ein Medium nach Anspruch 17, worin das Verhältnis von Amplituden eines der Eingangssummen- und -differenzsignale zu einem der verarbeiteten Summen- und Differenzsignalkomponenten im wesentlichen konstant ist.

19. Ein Medium nach Anspruch 17 oder 18, worin die verarbeitete Differenzsignalkomponente einen Wert besitzt, der mit Variation des Verhältnisses zwischen dem Eingangssummensignal und der verarbeiteten Differenzsignalkomponente variiert.

20. Ein Medium nach Anspruch 17, 18, oder 19, worin das Eingangssummensignal und das Eingangsdifferenzsignal Komponenten davon in ausgewählten Frequenzbändern aufweist, welche verändert sind, um Effekte künstlichen Nachhalls zu kompensieren.

21. Ein Verfahren zum Erzeugen einer Stereotonaufzeichnung von linken (L) und rechten (R) Stereoquellsignalen, worin die Summe der linken und rechten Stereoquellsignale als ein Summensignal (L+R) bereitgestellt wird und die Differenz zwischen den linken und rechten Stereoquellsignalen als Differenzsignal (L-R) bereitgestellt wird, gekennzeichnet durch:
(a) Erzeugen eines verarbeiteten Differenzsignals (L-R)ₚ durch selektives Verändern der relativen Amplituden von Frequenzkomponenten des Differenzsignals, so daß lautere Frequenzkomponenten des Differenzsignals relativ zu ruhigeren Frequenzkomponenten des Differenzsignals abgeschwächt werden;
(b) Erzeugen eines verarbeiteten Summensignals (L+R)ₚ durch selektives Verändern der relativen Amplituden von Frequenzkomponenten des Summensignals, so daß ausgewählte Summensignalkomponenten relativ zu anderen Summensignalkomponenten verstärkt werden;
(c) Kombinieren der linken und rechten Stereoquellsignale mit dem verarbeiteten Differenzsignal, und mit dem verarbeiteten Summensignal, um modifizierte linke (Lₒᵤₜ) und rechte (Rₒᵤₜ) Stereoausgangssignale zu modifizieren; und
(d) Betreiben eines Tonaufzeichnungsbauteils (320) als Antwort auf die modifizierten linken und rechten Stereoausgangssignale, um eine Tonaufzeichnung (322) herzustellen.

22. Ein Verfahren nach Anspruch 21, welches den zusätzlichen Schritt von kontinuierlichem und automatischem Verstärken eines der verarbeiteten Summen- und Differenzsignale als Funktion ihrer Größe relativ zu der eines der Summen- und Differenzsignale beinhaltet, um eine im wesentlichen konsistente Stereotrennung zwischen den linken und rechten Signalen für unterschiedliche Beträge von Stereoinformation innerhalb der linken und rechten Stereoquellsignale beizubehalten.

23. Ein Verfahren nach Anspruch 21 oder 22, worin der Schritt des Erzeugens eines verarbeiteten Differenzsignals künstliche Nachhallinformation in dem Differenzsignal verstärkt, und den zusätzlichen Schritt von selektivem Verstärken von Komponenten des Summensignals, und selektivem Abschwächen von Komponenten des Differenzsignals innerhalb ausgewählter Frequenzbänder beinhaltet, um ungeeignetes Verstärken von künstlicher Nachhallinformation in dem Differenzsignal zu kompensieren.

24. Ein Verfahren nach Anspruch 21, 22 oder 23, gekennzeichnet durch Aufzeichnen der modifizierten linken (Lₒᵤₜ) und rechten (Rₒᵤₜ) Stereoausgangssignale, welche herrühren von einem Verfahren gemäß irgendeinem der Ansprüche 10 bis 16.

25. Ein Verfahren nach irgendeinem der Ansprüche 10 bis 16 oder 24, worin die modifizierten linken (Lₒᵤₜ) und rechten (Rₒᵤₜ) Stereoausgangssignale herrühren von linken (L) und rechten (R) Signalen eines Stereotonsystems.

26. Ein elektronisches Stereosignal einer Stereotonaufzeichnung, wobei das Stereosignal linke (Lₒᵤₜ) und rechte (Rₒᵤₜ) Stereoausgangssignale umfaßt, welche modifiziert von linken (L) und rechten (R) Stereoquellsignalen sind, gekennzeichnet durch:
(a) das linke Ausgangssignal (Lₒᵤₜ) mit:
1. einer linken Stereoquellsignalkomponente (L),
2. einer verarbeiteten Differenzsignalkomponente (L-R)ₚ, welche ein Eingangsdifferenzsignal umfaßt, das die Differenz zwischen linken und rechten Stereoquellsignalen repräsentiert, die modifiziert sind, so daß lautere Frequenzkomponenten des Eingangsdifferenzsignals relativ zu ruhigeren Frequenzkomponenten des Eingangsdifferenzsignals abgeschwächt werden, und
3. einer verarbeiteten Summensignalkomponente (L+R)ₚ, welche ein Eingangssummensignal umfaßt, das die Summe der linken und rechten Stereoquellsignale repräsentiert, welche modifiziert sind, so daß ausgewählte Eingangssummenssignalkomponenten relativ zu anderen Eingangssummensignalkomponenten verstärkt werden,
(b) das rechte Ausgangssignal (Rₒᵤₜ) mit:
1. einer rechten Stereoquellsignalkomponente (R),
2. einer verarbeiteten Differenzsignalkomponente (L-R)ₚ, welche ein Eingangsdifferenzsignal umfaßt, das die Differenz zwischen linken und rechten Stereoquellsignalen repräsentiert, die modifiziert sind, so daß lautere Frequenzkomponenten des Eingangsdifferenzsignals relativ zu ruhigeren Frequenzkomponenten des Eingangsdifferenzsignals abgeschwächt werden, und
3. einer verarbeiteten Summensignalkomponente (L+R)ₚ, die ein Eingangssummensignal umfaßt, welches die Summe von linken und rechten Stereoquellsignalen repräsentiert, welche modifiziert sind, so daß ausgewählte Eingangssummensignalkomponenten relativ zu anderen Eingangssummensignalkomponenten verstärkt werden.

27. Ein Stereosignal nach Anspruch 26, worin das Verhältnis von Amplituden eines der Eingangssummen- und -differenzsignale zu einem der verarbeiteten Summen- und Differenzsignalkomponenten im wesentlichen konstant ist.

28. Ein Stereosignal nach Anspruch 26 oder 27, worin die verarbeitete Differenzsignalkomponente einen Wert hat, welcher mit der Variation des Verhältnisses zwischen dem Eingangssummensignal und der verarbeiteten Differenzsignalkomponente variiert.

29. Ein Stereosignal nach Anspruch 26, 27 oder 28, worin das Eingangssummensignal und das Eingangsdifferenzsignal Komponenten davon in ausgewählten Frequenzbändern, aufweisen, die verändert sind, um Effekte von künstlichem Nachhall zu kompensieren.

## Revendications

1. Appareil destine à modifier des signaux de somme (L+R) et de différence (L-R) stéréophoniques obtenus à partir de signaux d'entrée stéréophoniques gauche (L) et droit (R), pour produire des signaux de sortie stéréophoniques gauche (Lₒᵤₜ) et droit (Rₒᵤₜ), caractérisé par :
des moyens de traitement (17, 18, 19, 21, 22, 30; 40, 115, 117, 125, 127) qui réagissent aux signaux de somme et de différence en modifiant sélectivement les amplitudes relatives de composantes de fréquence du signal de différence, de façon que des composantes de fréquence de niveau sonore plus élevé du signal de différence soient atténuées par rapport à des composantes de fréquence de plus faible niveau sonore du signal de différence, en produisant ainsi un signal de différence traité (L-R)ₚ, et en modifiant sélectivement les amplitudes relatives de composantes de fréquence du signal de somme, de façon que des composantes de signal de somme sélectionnées soient renforcées par rapport à d'autres composantes de signal de somme, pour produire ainsi un signal de somme traité (L+R)ₚ, et
des moyens (25; 121) qui réagissent aux signaux de somme et de différence traités en produisant des signaux de sortie stéréophoniques gauche (Lₒᵤₜ) et droit (Rₒᵤₜ).

2. Appareil selon la revendication 1, dans lequel les moyens de traitement comprennent des moyens d'égalisation (115) qui sont destinés à modifier sélectivement les amplitudes relatives de composantes de fréquence du signal de différence (L-R), de façon que des composantes à des fréquences qui contiennent de façon statistique des composantes de niveau sonore plus élevé, soient atténuées par rapport à des composantes à des fréquences qui contiennent de façon statistique des composantes de plus faible niveau sonore.

3. Appareil selon la revendication 2, dans lequel les moyens de traitement comprennent des moyens d'égalisation supplémentaires (117) qui sont destinés à modifier sélectivement les amplitudes relatives de composantes de fréquence du signal de somme (L+R), de façon que des composantes dans une gamme de fréquences prédéterminée qui contient de façon statistique des composantes de signal de différence de niveau sonore plus élevé, soient relativement renforcées, et que des composantes à l'extérieur de la gamme de fréquences prédéterminée soient relativement atténuées.

4. Appareil selon la revendication 3, dans lequel les moyens d'égalisation et les moyens d'égalisation supplémentaires comprennent respectivement un premier égaliseur fixe (115) et un second égaliseur fixe (117).

5. Appareil selon la revendication 1, dans lequel les moyens de traitement comprennent des moyens analytiques (17) qui sont destinés à analyser le spectre de fréquence du signal de différence (L-R) et à générer des signaux de commande en fonction des amplitudes des composantes de fréquence du signal de différence dans des bandes de fréquences prédéterminées respectives, et des moyens d'utilisation (19) qui sont destinés à utiliser les signaux de commande précités pour déterminer la mesure dans laquelle les amplitudes de composantes du signal de différence sont modifiées dans les bandes de fréquences respectives.

6. Appareil selon la revendication 5,dans lequel les moyens de traitement sont conçus de façon à modifier sélectivement les amplitudes relatives de composantes de fréquence du signal de somme (L+R) dans les bandes de fréquences prédéterminées respectives, de façon que des composantes dans des bandes de fréquences de composantes de signaux de différence de niveau sonore supérieur soient renforcées par rapport à des composantes dans des bandes de fréquences de composantes de signal de différence de niveau sonore plus faible, et ils comprennent en outre des moyens d'utilisation supplémentaires (21) qui sont destinés à utiliser les signaux de commande pour déterminer la mesure dans laquelle les amplitudes de composantes du signal de somme sont modifiées dans les bandes de fréquences respectives.

7. Appareil selon l'une quelconque des revendications précédentes, comprenant des moyens de commande (30; 40) qui sont destinés à amplifier le signal de différence traité, en fonction de son amplitude comparée à celle du signal de somme, pour produire une image stéréophonique sensiblement constante pour différentes valeurs d'information vidéo dans les signaux d'entrée stéréophoniques gauche et droit.

8. Appareil selon l'une quelconque des revendications précédentes, comprenant des moyens (30; 40) qui sont destinés à contrôler les amplitudes relatives des signaux de somme et de différence pour détecter des conditions indiquant la présence d'une réverbération artificielle, et à modifier le signal de différence traité pour compenser des effets de réverbération artificielle.

9. Appareil pour réaliser un enregistrement sonore stéréophonique, comprenant un appareil selon l'une quelconque des revendications précédentes, et un dispositif d'enregistrement sonore connecté de façon à recevoir les signaux de sortie stéréophoniques gauche (Lₒᵤₜ) et droit (Rₒᵤₜ), pour réaliser un enregistrement sonore.

10. Un procédé de modification de signaux de source stéréophoniques gauche (L) et droit (R), ce procédé comprenant les étapes suivantes :
(a) on additionne de façon électronique les signaux gauche et droit de façon à produire un signal de somme (L+R), et on soustrait de façon électronique l'un des signaux gauche et droit de l'autre, pour produire un signal de différence (L-R);
caractérisé par les étapes supplémentaires suivantes :
(b) on forme un signal de différence traité (L-R)ₚ en modifiant sélectivement les amplitudes relatives de composantes de fréquence du signal de différence, de façon que des composantes de fréquence de niveau sonore plus élevé du signal de différence soient atténuées par rapport à des composantes de fréquence de plus faible niveau sonore du signal de différence;
(c) on forme un signal de somme traité (L+R)ₚ en modifiant sélectivement les amplitudes relatives de composantes de fréquence du signal de somme, de façon que des composantes de signal de somme sélectionnées soient renforcées par rapport à d'autres composantes de signal de somme; et
(d) on combine les signaux de source stéréophoniques gauche et droit avec le signal de différence traité, et avec le signal de somme traité, pour produire des signaux de sortie stéréophoniques modifiés gauche (Lₒᵤₜ) et droit (Rₒᵤₜ).

11. Un procédé selon la revendication 10, dans lequel aux étapes de formation de signaux de différence et de somme traités est ajoutée l'étape qui consiste à analyser le spectre de fréquence du signal de différence et à générer des signaux de commande en fonction des amplitudes de composantes de fréquence du signal de différence dans des bandes de fréquences prédéterminées respectives, et à utiliser les signaux de commande précités pour déterminer la mesure dans laquelle les amplitudes de composantes des signaux de différence et de somme sont modifiées dans les bandes de fréquences respectives.

12. Un procédé selon la revendication 10 ou 11, comprenant l'étape supplémentaire qui consiste à amplifier continuellement et automatiquement le signal de différence traité, en fonction de son amplitude comparée à celle du signal de somme, afin de maintenir une séparation stéréophonique sensiblement constante entre les signaux gauche et droit, pour différentes valeurs d'information stéréophonique dans les signaux de source stéréophoniques gauche et droit.

13. Un procédé selon la revendication 12, dans lequel l'étape d'amplification continuelle et automatique est accomplie en faisant la moyenne de la somme de (a) l'enveloppe de crête inversée du signal de somme, et (b) l'enveloppe de crête non inversée du signal de différence, afin de générer un signal de commande de réverbération, et en renforçant et en atténuant des composantes respectivement des signaux de somme et de différence, en fonction du signal de commande de réverbération.

14. Un procédé selon l'une quelconque des revendications 10 à 13, dans lequel l'étape de formation d'un signal de différence traité renforce l'information de réverbération artificielle dans le signal de différence, et comprenant l'étape supplémentaire qui consiste à renforcer sélectivement des composantes du signal de somme et à atténuer sélectivement des composantes du signal de différence, dans des bandes de fréquences sélectionnées, dans le but de compenser un renforcement inapproprié de l'information de réverbération artificielle dans le signal de différence.

15. Un procédé selon l'une quelconque des revendications 10 à 14, dans lequel l'étape de formation d'un signal de somme traité est effectuée en renforçant sélectivement les composantes de signal de somme dans des bandes de fréquences données, en proportion directe de l'amplitude des composantes de signal de différence dans les bandes de fréquences données.

16. Un procédé selon l'une quelconque des revendications 10 à 15, dans lequel l'étape de formation d'un signal de différence traité est effectuée en renforçant sélectivement les composantes de signal de différence dans des bandes de fréquences données, en proportion inverse de l'amplitude des composantes de signal de différence dans les bandes de fréquence données.

17. Un support sur lequel un enregistrement sonore stéréophonique a été enregistré, ce support étant conçu pour fournir des signaux de sortie stéréophoniques gauche (Lₒᵤₜ) et droit (Rₒᵤₜ) qui sont des versions modifiées de signaux de source stéréophoniques gauche (L) et droit (R), caractérisé en ce que :
(a) le signal de sortie gauche (Lₒᵤₜ) comprend :
1. une composante de signal de source stéréophonique gauche (L),
2. une composante de signal de différence traité (L-R)ₚ qui comprend un signal de différence d'entrée représentant la différence entre les signaux de source stéréophoniques gauche et droit modifiés de façon que des composantes de fréquences de niveau sonore supérieur du signal de différence d'entrée soient atténuées par rapport à des composantes de fréquence de niveau sonore plus faible du signal de différence d'entrée, et
3. une composante de signal de somme traité (L+R)ₚ qui comprend un signal de somme d'entrée représentant la somme de signaux de source stéréophoniques gauche et droit modifiés de façon que des composantes de signal de somme d'entrée sélectionnées soient renforcées par rapport à d'autres composantes de signal de somme d'entrée,
(b) le signal de sortie droit (Rₒᵤₜ) comprend :
1. une composante de signal de source stéréophonique droit (R),
2. une composante de signal de différence traité (L-R)ₚ qui comprend un signal de différence d'entrée représentant la différence entre des signaux de source stéréophoniques gauche et droit modifiés de façon que des composantes de fréquences de niveau sonore supérieur du signal de différence d'entrée soient atténuées par rapport à des composantes de fréquence de niveau sonore plus faible du signal de différence d'entrée, et
3. une composante de signal de somme traité (L+R)ₚ qui comprend un signal de somme d'entrée représentant les signaux de source stéréophoniques gauche et droit modifiés de façon que des composantes de signal de somme d'entrée sélectionnées soient renforcées par rapport à d'autres composantes de signal de somme d'entrée.

18. Un support selon la revendication 17, dans lequel le rapport d'amplitudes entre l'un des signaux de somme et de différence d'entrée et l'une des composantes de signaux de somme et de différence traités est pratiquement constant.

19. Un support selon la revendication 17 ou 18, dans lequel la composante de signal de différence traité a une valeur qui varie avec une variation du rapport entre le signal de somme d'entrée et la composante de signal de différence traité.

20. Un support selon la revendication 17, 18 ou 19, dans lequel le signal de somme d'entrée et le signal de différence d'entrée ont des composantes, dans des bandes de fréquences sélectionnées, qui sont modifiées pour compenser des effets de réverbération artificielle.

21. Un procédé de réalisation d'un enregistrement sonore stéréophonique à partir de signaux de source stéréophoniques gauche (L) et droit (R), dans lequel la somme des signaux de source stéréophoniques gauche et droit est fournie sous la forme d'un signal de somme (L+R) et la différence entre les signaux de source stéréophoniques gauche et droit est fournie sous la forme d'un signal de différence (L-R), caractérisé en ce que :
(a) on forme un signal de différence traité (L-R)ₚ en modifiant sélectivement les amplitudes relatives de composantes de fréquence du signal de différence, de façon que des composantes de fréquence de niveau sonore supérieur du signal de différence soient atténuées par rapport à des composantes de fréquence de niveau sonore inférieur du signal de différence;
(b) on forme un signal de somme traité (L+R)ₚ en modifiant selectivement les amplitudes relatives de composantes de fréquence du signal de somme, de façon que des composantes de signal de somme sélectionnées soient renforcées par rapport à d'autres composantes de signal de somme;
(c) on combine les signaux de source stéréophoniques gauche et droit avec le signal de différence traité et avec le signal de somme traité, pour fournir des signaux de sortie stéréophoniques gauche (Lₒᵤₜ) et droit (Rₒᵤₜ); et
(d) on fait fonctionner un dispositif d'enregistrement sonore (320) sous la dépendance des signaux de sortie stéréophoniques gauche et droit modifiés, pour réaliser un enregistrement sonore (322).

22. Un procédé selon la revendication 21, comprenant l'étape supplémentaire qui consiste à amplifier continuellement et automatiquement l'un des signaux de somme et de différence traités, en fonction de son amplitude comparée à celle de l'un des signaux de somme et de différence, afin de maintenir une séparation stéréophonique sensiblement constante entre les signaux gauche et droit pour différentes valeurs d'information stéréophonique dans les signaux de source stéréophoniques gauche et droit.

23. Un procédé selon la revendication 21 ou 22, dans lequel l'étape de formation d'un signal de différence traité renforce une information de réverbération artificielle dans le signal de différence, et comprenant l'étape supplémentaire qui consiste à renforcer sélectivement des composantes du signal de somme, et à atténuer sélectivement des composantes du signal de différence dans des bandes de fréquences sélectionnées, dans le but de compenser un renforcement inapproprié de l'information de réverbération artificielle dans le signal de différence.

24. Un procédé selon la revendication 21, 22 ou 23, caractérisé par l'enregistrement des signaux de sortie stéréophoniques gauche (Lₒᵤₜ) et droit (Rₒᵤₜ) modifiés qui sont obtenus par un procédé conforme à l'une quelconque des revendications 10 à 16.

25. Un procédé selon l'une quelconque des revendications 10 à 16 ou 24, dans lequel les signaux de sortie stéréophoniques gauche (Lₒᵤₜ) et droit (Rₒᵤₜ) modifiés sont obtenus à partir des signaux gauche (L) et droit (R) d'un système sonore stéréophonique.

26. Un signal stéréophonique électronique d'un enregistrement sonore stéréophonique, le signal stéréophonique comprenant des signaux de sortie stéréophoniques gauche (Lₒᵤₜ) et droit (Rₒᵤₜ) qui sont des versions modifiées de signaux de source stéréophoniques gauche (L) et droit (R), caractérisé en ce que :
(a) le signal de sortie gauche (Lₒᵤₜ) comprend :
1. une composante de signal de source stéréophonique gauche (L),
2. une composante de signal de différence traité (L-R)ₚ qui comprend un signal de différence d'entrée représentant la différence entre des signaux de source stéréophoniques gauche et droit modifiés de façon que des composantes de fréquence de niveau sonore supérieur du signal de différence d'entrée soient atténuées par rapport à des composantes de fréquence de niveau sonore inférieur du signal de différence d'entrée, et
3. une composante de signal de somme traité (L+R)ₚ qui comprend un signal de somme d'entrée représentant la somme de signaux de source stéréophoniques gauche et droit modifiés de façon que des composantes de signal de somme d'entrée sélectionnées soient renforcées par rapport à d'autres composantes de signal de somme d'entrée,
(b) le signal de sortie droit (Rₒᵤₜ) comprend :
1. une composante de signal de source stéréophonique droit (R),
2. une composante de signal de différence traité (L-R)ₚ qui comprend un signal de différence d'entrée représentant la différence entre des signaux de source stéréophoniques gauche et droit modifiés de façon que des composantes de fréquence de niveau sonore supérieur du signal de différence d'entrée soient atténuées par rapport à des composantes de fréquence de niveau sonore inférieur du signal de différence d'entrée, et
3. une composante de signal de somme traité (L+R)ₚ qui comprend un signal de somme d'entrée représentant la somme de signaux de source stéréophoniques gauche et droit modifiés de façon que des composantes de signal de somme d'entrée sélectionnées soient renforcées par rapport à d'autres composantes de signal de somme d'entrée.

27. Un signal stéréophonique selon la revendication 26, dans lequel le rapport d'amplitudes entre l'un des signaux de somme et de différence d'entrée et l'une des composantes de signaux de somme et de différence traités est pratiquement constant.

28. Un signal stéréophonique selon la revendication 26 ou 27, dans lequel la composante de différence de signal traité a une valeur qui varie sous l'effet d'une variation du rapport entre le signal de somme d'entrée et la composante de signal de différence traité.

29. Un signal stéréophonique selon la revendication 26, 27 ou 28, dans lequel le signal de somme d'entrée et le signal de différence d'entrée ont des composantes dans des bandes de fréquences sélectionnées qui sont modifiées pour compenser des effets de réverbération artificielle.
